(19) **Europäisches Patentamt European Patent Office Office européen des brevets**

(11) **EP 4 556 929 B1**

(12) **EUROPEAN PATENT SPECIFICATION**

(45) Date of publication and mention
of the grant of the patent:
**11.03.2026 Bulletin 2026/11**

(21) Application number: **23209953.1**

(22) Date of filing: **15.11.2023**

(51) International Patent Classification (IPC):
$G01R\ 31/62^{(2020.01)}$          $G01R\ 31/72^{(2020.01)}$

(52) Cooperative Patent Classification (CPC):
**G01R 31/62; G01R 31/72;** G01R 31/50

(54) **METHOD AND PROCESSING SYSTEM FOR USE WITH AN ASSET OF AN ELECTRIC POWER SYSTEM, AND METHOD OF PROVIDING A PHYSICS INFORMED MACHINE LEARNING MODEL**

VERFAHREN UND VERARBEITUNGSSYSTEM ZUR VERWENDUNG MIT EINEM VERMÖGENSWERT EINES ELEKTRISCHEN STROMVERSORGUNGSSYSTEMS UND VERFAHREN ZUR BEREITSTELLUNG EINES PHYSIKINFORMIERTEN MASCHINENLERNMODELLS

PROCÉDÉ ET SYSTÈME DE TRAITEMENT DESTINÉS À ÊTRE UTILISÉS AVEC UN ACTIF D'UN SYSTÈME D'ALIMENTATION ÉLECTRIQUE, ET PROCÉDÉ DE FOURNITURE D'UN MODÈLE D'APPRENTISSAGE AUTOMATIQUE INFORMÉ DE LA PHYSIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**21.05.2025 Bulletin 2025/21**

(73) Proprietor: **Hitachi Energy Ltd**
**8050 Zürich (CH)**

(72) Inventors:
• **Chakravorty, Jhelum**
**H3G1Y2 Montreal, Québec (CA)**
• **Ripamonti, Nicolo**
**5400 Baden (CH)**
• **Yada, Susumu**
**117 61 Stockholm (SE)**
• **Luvisotto, Michele**
**723 34 Västerås (SE)**

• **Mukherjee, Pritam**
**722 27 Västerås (SE)**

(74) Representative: **Meier, Florian**
**meier ip**
**Buschingstraße 65 (6. OG)**
**81677 München (DE)**

(56) References cited:
**CN-A- 116 953 444    US-A1- 2023 082 184**

• **XU YANWEN ET AL: "Physics-informed machine learning for reliability and systems safety applications: State of the art and challenges",** RELIABILITY ENGINEERING AND SYSTEM SAFETY., vol. 230, 1 February 2023 (2023-02-01), GB, pages 108900, XP093065254, ISSN: 0951-8320, DOI: 10.1016/j.ress.2022.108900

**Description**

TECHNICAL FIELD

Embodiments of the invention relate to processing systems and methods for controlling and/or monitoring an electric power system. Embodiments of the invention relate in particular to processing systems and methods operative to process measurements obtained at or in proximity to an asset of the electric power system and to trigger actions responsive to the processing.

BACKGROUND

Modern electric power systems comprise several complex assets, such as transformers or shunt reactors. Failure or malfunction of such assets can have potentially catastrophic consequences. Monitoring of such assets can represent a considerable challenge. For illustration, some assets may have a tank comprising a tank wall. Local losses in such assets can be difficult to monitor, in part due to structural components of the tank wall. As a consequence, there is a risk that potential issues related to, e.g., local losses in such complex assets may remain unnoticed for undesirably long time periods.

US 2020/0293594 A1 discloses a technique in which an object is modeled with a differential equation. F. Bragone et al., "Physics-informed neural networks for modelling power transformer's dynamic thermal behaviour", Electric Power Systems Research Volume 211, October 2022, 108447, Elsevier (2022) discloses thermal modelling of power transformers using physics-informed neural networks (PINNs). C. Moya et al., "DeepONet-Grid-UQ: A Trustworthy Deep Operator Framework for Predicting the Power Grid's Post-Fault Trajectories", arXiv:2202.07176 discloses a data-driven method for the prediction of power system post-fault trajectories.

Processing techniques as discussed in the before-mentioned documents provide data-driven techniques suitable for assets. Such techniques are beneficial in that they mitigate the risk of human-induced error. However, there is still a need for enhanced techniques that allow local losses, malfunctions, or other potentially relevant operating situations to be detected. For illustration, it would be desirable to provide techniques capable of using measurements obtained from, e.g., an instrumentation location externally of an asset tank wall to infer conditions at locations for which measurements do not reliably reflect thermal diffusion processes in an asset due to, e.g., structural components of a tank wall. Generally, there is a need for techniques suitable for use in association with an asset of an electric power system, which provide enhanced robustness.

SUMMARY

It is an object of the invention to provide methods and/or processing systems that provide enhanced techniques of processing measurements obtained for an asset of an electric power system. There is in particular a need for such methods and/or processing systems that can determine one or several parameters associated with the asset and that provide enhanced robustness.

According to the invention, methods and a processing system as recited in the independent claims are provided. The dependent claims define preferred or advantageous embodiments.

According to exemplary embodiments, there are provided methods and processing systems operative to process measurements obtained on or in proximity to an asset of an electric power system using a data-driven processing technique. The data-driven processing technique may be a physics informed data-driven processing technique operative to determine one or several parameters of the asset, with the physics informed data-driven processing technique having embedded therein knowledge of a differential equation, such as a partial differential equation (PDE), e.g. a linear PDE, that links the various parameters to each other. Input data for the data-driven processing technique is generated based on the measurements. Generating the input data may comprise identifying measurement locations at which measurements were obtained but at which the measurements are unreliable in the sense that the measurements do not conform with the physics knowledge embedded in the data-driven processing technique.

Enhanced robustness is attained by generating the input data for the data-driven processing technique in a manner which takes into consideration at which measurement locations the measurements are determined by the physical process (such as thermal diffusion) embedded in the data-driven processing technique.

Output is generated based on the determined one or several parameter(s). The output may comprise a warning, alert, alarm or a control command that acts on electric power system equipment.

The data-driven processing technique may comprise a physics informed data-driven processing technique operative to determine one or several parameters of the asset, with the physics informed data-driven processing technique having embedded therein knowledge of a physical process (e.g., thermal diffusion) described by a partial differential equation (PDE), e.g. a linear PDE. The physics informed data-driven processing technique may be operative to determine a first parameter and a second parameter as a function of both spatial location on the asset and time. The first parameter and the second parameter may be related to each other by a PDE, in particular by a linear PDE. The PDE may be dependent on a time derivative of the second parameter and both a first order partial time derivative of the first parameter and a second order partial spatial derivative of the first parameter (e.g., a Laplace operator applied to the first parameter). The PDE may be a diffusion equation, e.g., a thermal diffusion equation.

Thereby, the data-driven processing technique embeds the physical relationship between several parameters that are linked to each other by the physical relationship.

An example is heat and temperature that are linked to each other by a thermal diffusion equation. By determining these first and second parameters as a function of time and location and using the PDE linking the first and second parameters to each other, more robust determination of the parameter(s) can be obtained. Robust determination of parameter(s) is attained by combining the use of a physics informed data-driven processing technique and a preprocessing of measurements that identifies measurement locations at which the measurements do not reflect the physical process embedded in the physics informed data-driven processing technique data-driven processing techniques.

The data-driven processing technique may be operative to use temperature measurements obtained for a plurality of measurement locations on a tank wall of the asset (e.g., of a transformer tank wall or a shunt reactor tank wall) to determine heat in a spatially resolved, optionally in a spatiotemporally resolved manner.

Thereby, the processing system and processing method can be used for identifying local losses (such as heat losses identified in a spatiotemporally resolved manner).

The data-driven processing technique may be operative to use temperature measurements obtained for a plurality of measurement locations on a tank wall of the asset (e.g., of a transformer tank wall or a shunt reactor tank wall) to determine temperatures for regions at which no reliable temperature measurements are available, e.g., due to structural components of the tank wall such as reinforcements.

Thereby, additional information not obtainable using conventional techniques is available for use in generating an output, such as an alert, warning, alarm, or other data (such as a control command) that trigger an action in the electric power system.

The processing system and processing method may be operative to create a baseline for thermal dynamics during normal operation of the asset. The processing system and processing method may be operative to identify deviations from the baseline and generate output based on the deviations.

Thereby, the processing system and processing method may be operative to generate output (such as a warning, alert, alarm or a control command that acts on electric power system equipment) based on an anomaly (in the sense of a deviation from the baseline thermodynamic behavior) that is automatically detected.

A method for use in association with an asset of an electric power system according to an embodiment comprises receiving, at at least one interface of a processing system, data comprising measurements for several different measurement locations at or in proximity to the asset. The method comprises performing, by at least one processing circuit of the processing system, a determination of at least one parameter of the asset, comprising generating input data for a physics informed data-driven processing technique based at least on the measurements, comprising identifying a subset of the measurement locations for which the measurements are reliable and using measurements obtained at the identified subset for generating the input data, and applying the physics informed data-driven processing technique to the input data to determine the at least one parameter. The method comprises generating, by the processing system, output based on the at least one parameter.

Thereby, generation of input data for the physics informed data-driven processing technique includes a determination of measurements that are reliable for being processed by the physics informed data-driven processing technique. Measurements that do not reflect the physical process embedded in the physics informed data-driven processing technique may be removed, i.e., are not used for generating the input data for the physics informed data-driven processing technique. Robustness and accuracy are enhanced thereby.

The measurements may comprise spatially resolved temperature measurements. Identifying the subset of measurement locations may comprise identifying spatial regions in which the spatially resolved measurements are not indicative of a physical process (such as a thermal diffusion process) embedded in the physics informed data-driven processing technique.

Thereby, the input data for the physics informed data-driven processing technique can be generated based on measurements obtained at measurement locations (e.g., at measurement locations on a tank wall of the asset) that reflect the physical process (e.g., thermal diffusion) embedded in the physics informed data-driven processing technique, while the input data is generated independent of other measurements obtained at other measurement locations (e.g., at other measurement locations on a tank wall of the asset) that do not reflect the physical process (e.g., thermal diffusion). Robustness is enhanced thereby.

The measurements that are not indicative of the physical process embedded in the physics informed data-driven processing technique may comprise measurements obtained at locations at which structural components of the asset attenuate thermal radiation and/or act as heat sink.

Thereby, the risk of incorrect parameter determination for the asset can be mitigated. The technique can mitigate the risk that thermal measurements not indicative of thermal diffusion for which the physics informed data-driven processing technique has been trained reduce reliability of the provided output.

Identifying the subset of measurement locations may comprise at least one of performing an image segmentation based on a temperature gradient determined from the temperature measurements and/or based on construction data for the asset.

Thereby, regions (e.g., on a tank wall of the asset) may be identified, based on the measurements, in which the measurements do not reflect the physical process (e.g., thermal diffusion) embedded in the physics informed data-driven processing technique.

The segmentation may be based on a spatial derivative of the measurements.

Thereby, boundaries of regions (e.g., on a tank wall of the asset) may be identified, based on the measurements, in which a first spatial derivative of the measurements exhibits a discontinuity, indicating that the thermal measurements at that region are not governed by thermal diffusion processes. The input data for the physics informed data driven processing technique may be generated independently of regions having a boundary at which a first spatial derivative of the measurements exhibits a discontinuity.

The spatially resolved temperature measurements may comprise pixel or voxel values of at least one thermal image of at least one wall of a tank of the asset.

Thereby, parameter(s) of the asset may be determined based on a thermal image or several thermal images showing one or several of the sidewall(s) and/or cover of the tank. Such measurements can be obtained without requiring instrumentation in an interior of the tank.

The at least one parameter may be indicative of electric loss power.

Thereby, the method is operative to identify local loss(es) in the asset.

The physics informed data-driven processing technique may comprise at least one physics informed machine learning (PIML) model.

Thereby, a data-driven processing technique can be used to determine the at least one parameter in a manner which embeds at least one physical relationship with which the at least one parameter complies, such as a partial differential equation (PDE), in particular a linear PDE, or other differential equation.

The at least one PIML model may be trained using a loss function that includes a term dependent on a residual of the PDE.

Thereby, the PIML model provides output that complies with the physical relationship embedded in the PIML model (by virtue of the loss function term that is dependent on the PDE residual). This enforces that physically reasonable solutions are identified by the data driven processing technique.

The at least one PIML model may have an output operative to output a first parameter (such as temperature) for each one of a plurality of spatial locations, and a second parameter (such as heat) for each one of the plurality of spatial locations. The at least one PIML model may be operative to provide these values at an output for each one of a plurality of times.

Thereby, the at least one PIML model is operative to determine the at least one parameter in a spatially resolved manner, optionally in a spatiotemporally resolved manner. This facilitates determining the one or several parameters in a spatially resolved manner such that the physical relationship embedded in the at least one PIML model (such as a heat diffusion equation) is complied with.

The at least one PIML model may have an input operative to receive spatial coordinates, time, measurements (such as thermal measurements), and at least one operating condition (such as a load current) for the asset.

Thereby, the determination of the at least one parameter is facilitated for situations in which the at least one parameter is dependent on the operating condition. For illustration, determination of heat and/or temperature in a spatially or spatiotemporally resolved manner is facilitated, with the PIML model receiving inter alia the asset load current or load power at the input.

The at least one PIML model may comprise a first plurality of neural network (NN) layers having a first input layer, a second plurality of NN layers operative to process a first output of the first plurality of NN layers and having a second output to provide a first parameter (such as temperature), and a third plurality of NN layers operative to process the first output of the first plurality of NN layers and having a third output to provide a second parameter (such as heat) related to the first parameter by means of a physical relationship (such as thermal diffusion) embedded in the at least one PIML model (e.g., by using a PIML model that was trained with a loss function dependent on the a residual of a thermal diffusion partial differential equation).

Thereby, training of the at least one PIML model is facilitated. The portions of the PIML model that determine the several parameters related to each other by the physical relationship share several hidden layers (the first plurality of NN layers).

The at least one PIML model may be operative to provide a first parameter and a second parameter, wherein the at least one PIML model embeds a PDE that is dependent on the first parameter and the second parameter.

Thereby, the at least one PIML model is operative to determine several parameters that are interrelated with each other by means of a physical relationship (such as a thermal diffusion equation). Robustness and reliability is enhanced thereby. In particular, the at least one PIML model enforces that physically reasonable solutions are found for the first and second parameters, by virtue of the PDE embedded in the PIML model. As will be appreciated by the skilled artisan, embedding the PDE into the PIML model is attainable by training the PIML model with a loss function that includes a loss function term dependent on the PDE residual.

The PDE may be a linear PDE. The PDE may be a PDE that includes a first order partial time derivative and at least two second order partial spatial derivatives (such as a 2D or 3D Laplace operator) of the first parameter and/or the second parameter.

Thereby, the PIML model is operative to determine several parameters that are linked to each other by a diffusion type PDE.

The PDE may comprise a thermal diffusion relationship.

Thereby, the method is operative to determine temperature and/or heat in a spatially resolved manner, optionally in a spatiotemporally resolved manner. This is useful for identifying asset conditions that are associated with local heat and temperature increases, as may be the case for local losses.

The at least one PIML model may embed a thermal diffusion partial differential equation, PDE.

Thereby, the method is operative to determine temperature and/or heat in a manner that complies with the physical process of thermal diffusion.

The at least one PIML model may be operative to receive, at its input, spatially resolved measurements of the first parameter (e.g., thermal measurements captured using a thermal camera) and to provide, at its output, both spatially resolved values for both the first parameter (e.g., temperature) and the second parameter (e.g., heat). The at least one PIML model may be operative such that its input does not receive measurements of the second parameter. The at least one PIML model may be operative such that its input receives measurements of at least one operating parameter (such as a load current and/or load power) that affects the second parameter.

Thereby, the method is operative to determine the first parameter (e.g., temperature) and the second parameter (e.g., heat) in a manner that takes in account the physical process that links the first and second parameters, without requiring measurements of the second parameter to be available for generating the input data for the at least one PIML model.

The at least one PIML model comprises at least one output layer operative to enforce positivity of the temperature and the heat determined by the at least one PIML model.

Thereby, robustness is enhanced.

The at least one output layer may comprise an output layer that determines a modulus (i.e., absolute value).

Thereby, robustness is enhanced.

The at least one PIML model may be a PIML model that is trained using training data captured for the asset or captured on a further asset having identical or similar construction characteristics as the asset. The training data may comprise spatiotemporally resolved temperature measurements.

Thereby, thermal diffusion processes and/or local losses in the asset can be determined in a data-driven manner while the determined parameter(s) comply with the underlying physical process (e.g., thermal diffusion).

The method further comprises training, by the processing system or by a computing system separate from the processing system, the at least one physics informed data-driven processing technique.

Thereby, the at least one physics informed data-driven processing technique is set up for use during inference.

The training may comprise a history aware training.

Thereby, enhanced robustness of the obtained parameter(s) determined during inference may be obtained using a technique that allows training to be performed efficiently.

The history aware training may be performed using a loss function (e.g., a loss function to be maximized or minimized during training) wherein a loss function value for a time instant during training is dependent on a loss function value for at least one previous time instant during training.

Thereby, enhanced robustness of the obtained parameter(s) determined during inference may be obtained using a technique that allows training to be performed efficiently.

The history-aware training may be performed using a loss function to be maximized or minimized. The loss function may include a weight factor that is dependent on a training loss in a past time instant of the training and/or introduces a temporal gradient regularization and/or penalizes a training loss based on a derivative of the loss function.

Thereby, enhanced robustness of the obtained parameter(s) determined during inference may be obtained using a technique that allows training to be performed efficiently. It has surprisingly been found that a weight function that is dependent on a time derivative of a loss function at several previously instances provides advantages both for robustness and training efficiency.

The method may further comprise performing a validation of the trained physics informed data driven processing technique, wherein the validation is performed based at least on spatially resolved heat values obtained by performing a simulation of the asset thermodynamics.

Thereby, the physics informed data driven processing technique can be set up for determining temperature and heat in a spatially (optionally in a spatiotemporally) resolved manner during inference, without requiring spatially resolved heat measurements to be available for validation.

The method may further comprise interfacing, by the processing system or by the computing system, with an asset simulator that simulates thermal behavior of the asset to perform a model validation of the at least one PIML model.

Thereby, the physics informed data driven processing technique can be set up for determining temperature and heat in a spatially (optionally in a spatiotemporally) resolved manner during inference, without requiring spatially resolved heat measurements to be available for validation.

The asset may comprise a tank having a tank wall. The data may comprise thermal measurement data obtained at and/or within the tank wall.

Thereby, the method is operative to determine temperature and/or heat in a spatially resolved manner, optionally in a spatiotemporally resolved manner. This is useful for identifying asset conditions that are associated with local heat and temperature increases, as may be the case for local losses.

The at least one parameter may comprise a temperature and/or heat.

Thereby, the method is operative to determine temperature and/or heat in a spatially resolved manner, optionally in a spatiotemporally resolved manner. This is useful for identifying asset conditions that are associated with local heat and temperature increases, as may be the case for local losses.

The tank wall may have a bottom surface, several side surfaces, and a cover. The data may comprise thermal measurement data obtained at least for two or more (optionally all of the several side surfaces). The data may also comprise thermal measurement data obtained for the cover.

Thereby, data that can be readily captured on the portions of a tank wall (e.g., of a transformer or shunt reactor) is utilized to obtain a more thorough determination of possible local losses than obtainable based on, e.g., measurements that are performed at a single tank wall only. This is beneficial for determining thermal behavior along several of the tank sidewalls and, optionally, the cover.

The data may comprise measurements obtained on a portion of the tank wall proximate to a high voltage side of the asset and another portion of the tank wall proximate to a low voltage side of the asset.

Thereby, a more thorough thermodynamic modelling of the asset can be performed for, e.g., identifying local losses.

Preprocessing the measurements may comprise applying a coordinate transform to transform coordinates of pixel or voxel values comprised by the measurements to a world coordinate system of the asset.

Thereby, variations in attitude and/or location of measurement instrumentation (such as a thermal camera or other thermal sensors) relative to the tank wall may be compensated. Increased robustness and reliability is attained.

Alternatively or additionally, the preprocessing may comprise performing a segmentations of at least one array of pixel or voxel values comprised by the measurements to identify zones in which the measurements are unreliable.

Thereby, measurements for areas in which the measurements have reduced value for the data-driven processing technique (e.g., because of the presence of structural tank components, such as tank reinforcements, e.g., tank bars) may be removed from consideration by the preprocessing. This may comprise a cropping of the pixel or voxel arrays. This has the further technical advantage that regions in which, e.g., thermal measurements are made unreliable by the presence of tank reinforcements can be identified from the thermal measurement data themselves. Cropping reduces the risk of artefacts at the regions where the tank reinforcements might otherwise lead to discontinuities in temperature measurements (caused by increased thermal shielding of the tank reinforcements).

Alternatively or additionally, the preprocessing may comprise determining pixel or voxel values for zones in which structural components of the asset reduce the reliability of the measurements, comprising an interpolation, extrapolation, or a regression technique.

Thereby, measurements for areas in which the measurements have reduced value for the data-driven processing technique (e.g., because of the presence of structural tank components, such as tank reinforcements, e.g., tank bars) may be replaced by more reliable substitute data obtained using interpolation, extrapolation, or a regression technique.

The measurements may comprise spatially resolved thermal measurements.

Thereby, spatiotemporal temperature and/or changes, e.g., on a tank wall of the asset, may be used for the identification of potential issues with asset operation, which can be used to trigger an alert, alarm, or control action acting on electric power system equipment, based on the at least one parameter.

The spatially resolved thermal measurements may be received from measurement instrumentation, which may comprise one, several, or all of: at least one thermal camera, at least one thermocouple, at least one fiber optic sensor operative to sense temperature.

Thereby, input for the physics informed data-driven processing technique may be generated based on such thermal measurements.

The data-driven processing technique may be operative to model thermal dynamics in the asset, taking into account thermal diffusion, in a spatially resolved manner along at least two spatial directions.

Thereby, thermal effects may be embedded in the data-driven processing technique (e.g., by means of a PIML model that has been trained with a loss function that depends on a residual of a thermal diffusion equation). The identification of local losses is facilitated by determining temperature and/or heat as a function of position along at least the plane of one or several sidewalls of an asset tank. Additional information is obtained, which is useful for determining which output is to be generated. For illustration, based on the location of a temperature buildup identified based on a 2D thermal diffusion model embedded in the data driven processing technique, it is possible to determine which one of the following actions is to be performed: alert generation; alarm generation; triggering a control command affecting primary system equipment of the electric power system.

The output may comprise output for an operator interface of the electric power system.

Thereby, the determined at least one parameter can be used for warning, alert and/or alarm generation. The method may, thus, be an operation method of a warning, alert and/or alarm generation system, with the warning, alarm or alert being selectively raised based on the determined at least one parameter.

Alternatively or additionally, the output may comprise output that triggers at least one control action within the electric power system. The control action may affect primary system equipment, e.g., by changing an asset load current and/or asset load power, by operating a protective device (such as a circuit breaker or switch), changing a tap changer position, or other control operations.

The asset may have a tank wall, wherein the input data for the data driven processing technique may be generated based on measurements obtained for the tank wall of the asset.

Thereby, measurements that can be acquired from an outer side of the tank wall may be used in the processing method. This reduces the risk of measurement instrumentation within the tank wall introducing potential issues within the tank.

The tank wall may contain therein an insulating fluid, such as an insulation oil.

Thereby, the techniques disclosed herein can be harnessed in association with oil insulated assets.

A method of controlling an electric power system according to an embodiment comprise performing, by a processing system, the method of any one aspect or embodiment disclosed herein to identify local losses in the asset of the electric power system (e.g., as a function of location in an asset tank of the asset), and performing, by the processing system or a control system operatively coupled with the processing system, at least one control operation based on the output.

Thereby, the techniques disclosed herein are used for automatically performing control operations.

A method of providing a PIML model according to an aspect comprises: obtaining, by a computing system, training data based on measurements captured on a tank wall of an asset. The method comprises training, by the computing system, the PIML model using the training data, wherein the training comprises a history aware training in which a loss function at a training time instant is dependent on a loss function in at least one past training time instant of the training.

Thereby, convergence of the training is enhanced and accuracy of the output (i.e., of the at least one parameter) is enhanced. The history aware training takes into account that the dynamics of a physical process (such as a diffusion process) is such that accuracy of the dynamics can be affected by an estimation error in the past. Thus, the PIML model is trained in a manner that takes into account the fact that a physical relationship (such as a diffusion process) is embedded in the PIML model (e.g., penalizing, during training, a residual of a PDE that represents the physical relationship). This is of particular relevance for setting up the PIML model for predicting two parameters related to each other by a diffusion process (such as heat and temperature that are related by a thermal diffusion process) in a spatiotemporally resolved manner.

The history aware training may be dependent on a time derivative of the loss function.

Thereby, convergence of the training is enhanced and accuracy of the output (i.e., of the at least one parameter) is enhanced. The history aware training takes into account the variation of the loss function in the past.

The history-aware training may be performed using a loss function to be maximized or minimized. The loss function may include a weight factor that is dependent on a training loss in a past time instant of the training and/or introduces a temporal gradient regularization and/or penalizes a training loss based on a derivative of the loss function.

Thereby, enhanced robustness of the obtained parameter(s) determined during inference may be obtained using a technique that allows training to be performed efficiently. It has surprisingly been found that a weight function that is dependent on a time derivative of a loss function at several previously instances provides advantages both for robustness and training efficiency.

The method may further comprise a PIML model validation. The PIML model validation may comprise using a spatially resolved heat prediction provided by the PIML model to determine, by the computing system or a simulator communicatively interfaced with the computing system, a spatially resolved simulated temperature distribution, and comparing the spatially resolved temperature prediction with a spatially resolved temperature measurement.

Thereby, performance of the PIML model may be assessed without requiring measurements for a ground truth of heat, which may be much more challenging to obtain than temperature measurements.

The method may comprise providing PIML model data obtained in the training for use in processing measurements of any one of the preceding claims.

Thereby, the at least one PIML model is set up and provided for use in inferring the at least one parameter.

The method of may be performed automatically by a computing system, which may be integral with or communicatively coupled to the processing system that uses the PIML model during inference.

The PIML model may have a first portion operative to provide a first parameter (such as temperature) as a first output, and a second portion operative to provide a second parameter (such as heat) as a second output, with the first and second parameters being related to each other by a physical relationship (such as thermal diffusion) that is embedded in the PIML model during training.

Thereby, robustness and accuracy obtained during inference can be enhanced.

Training the PIML model may comprise a training phase in which first PIML model parameters of the first portion are adjusted while keeping second PIML model parameters of the second portion constant, and a further training phase in which the second PIML model parameters of the second portion are adjusted while keeping the first PIML model parameters of the first portion constant.

Thereby, convergence of the training and accuracy obtained during inference are enhanced.

The loss function may comprise a term that is dependent on a residual of a PDE embedded in the PIML model (such as a residual of the thermal diffusion equation).

Thereby, the PIML model is trained to provide spatiotemporal values for the parameter(s) (such as temperature and/or heat) that comply with the PDE embedded in the PIML model.

The method of providing the PIML model may be performed using the measurements, wherein the measurements are captured on an asset having identical or similar construction as the asset for which the PIML model is to be used during inference.

Thereby, the PIML model can be trained using measurements captured during a factory test phase.

The method of providing the PIML model may be performed using the measurements, wherein the measurements are captured on the asset for which the PIML model is to be used during inference.

Thereby, the PIML model can be trained using measurements captured during, e.g., a factory test phase.

The measurements used in the PIML model training may comprise thermal measurements captured in a spatiotemporally resolved manner.

Thereby, the thermal dynamics observed during, e.g., a factory test can be used for training the PIML model.

The measurements used for the training may comprise thermal camera images. The thermal camera images may comprise a sequence of thermal camera images, such as at least 50 or at least 100 thermal camera images.

Thereby, the PIML model can be trained using a series of thermal camera images captured in, e.g., a factory test setting.

The method of providing the PIML model may comprise performing, by the computing system or by a simulator with which the computing system is communicatively interfaced, thermal modelling of the asset, to establish a ground truth for heat data in the PIML model training.

Thereby, heat data that may be challenging to measure can be established using thermal modelling in the training phase. It is not required to perform the thermal modelling during inference, as the knowledge of the thermal diffusion equation is embedded in the PIML model as trained.

Additional features of the PIML model that may be used in the method of providing the PIML model correspond to the features explained with reference to the method for use in association with an asset as disclosed above and elsewhere herein.

The method of providing the PIML model may comprise generating the training data based on the measurements, wherein generating the training data comprises identifying a subset of the measurement locations for which the measurements are reliable and using measurements obtained at the identified subset for generating the training data.

Thereby, generation of training data includes a determination of measurements that are reliable for training the PIML model. Measurements that do not reflect the physical process embedded in the PIML model may be removed, i.e., are not used for the training. Robustness is enhanced thereby.

The measurements may comprise spatially resolved temperature measurements. Identifying the subset of measurement locations may comprise identifying spatial regions in which the spatially resolved measurements are not indicative of a physical process (such as a thermal diffusion process) embedded in the physics informed data-driven processing technique.

Thereby, the training can be performed based on measurements obtained at measurement locations (e.g., at measurement locations on a tank wall of the asset at which the temperature is indicative of thermal diffusion in the asset) that reflect the physical process (e.g., thermal diffusion) embedded in the PIML model. Measurements obtained at other measurement locations (e.g., at other measurement locations on a tank wall of the asset at which the presence of heat sinks or thermal radiation attenuators render have the effect that the thermal measurements do not need to be indicative of thermal diffusion in the asset) that do not reflect the physical process (e.g., thermal diffusion) are not used for the training. Robustness is enhanced thereby.

The measurements that are not indicative of the physical process embedded in the PIML model may comprise measurements obtained at locations at which structural components of the asset attenuate thermal radiation and/or act as heat sink.

Thereby, the PIML model is trained in a manner which enhanced accuracy and robustness during inference.

In the method of providing the PIML model, identifying the subset of measurement locations may comprise at least one of performing an image segmentation based on a temperature gradient determined from the temperature measurements and/or based on construction data for the asset.

Thereby, regions (e.g., on a tank wall of the asset) may be identified, based on the measurements, in which the measurements do not reflect the physical process (e.g., thermal diffusion) embedded in the physics informed data-driven processing technique.

In the method of providing the PIML model, the segmentation may be based on a spatial derivative of the measurements.

Thereby, boundaries of regions (e.g., on a tank wall of the asset) may be identified, based on the measurements, in which a first spatial derivative of the measurements exhibits a discontinuity, indicating that the thermal measurements at that region are not governed by thermal diffusion processes. The training data may be generated independently of regions having a boundary at which a first spatial derivative of the measurements exhibits a discontinuity.

In the method of providing the PIML model, the spatially resolved temperature measurements may comprise pixel or voxel values of at least one thermal image of at least one wall of a tank of the asset.

Thereby, the PIML model can be trained for use in determining thermodynamic behavior and/or identifying local losses in the asset.

Additional preprocessing steps that can be applied to the measurements to generate the training data for use in the PIML model training correspond to the features explained with reference to the method for use in association with an asset hereinabove and elsewhere herein. Such preprocessing steps may comprise, in particular, one, several, or all of coordinate transform(s), cropping, interpolation and/or extrapolation.

A processing system according to an embodiment comprises at least one interface operative to receive data comprising measurements for several different measurement locations at or in proximity to the asset. The processing system comprises at least one processing circuit operative to perform a determination of at least one parameter of the asset. The at least one processing circuit is operative to generate input data for a physics informed data-driven processing technique based at least on the measurements, comprising identifying a subset of the measurement locations for which the measurements are reliable and using measurements obtained at the identified subset to generate the input data. The at least one processing circuit is operative to apply the physics informed data-driven processing technique to the input data to determine the at least one parameter. The processing system is operative to generate output based on the at least one parameter.

Thereby, the processing system is operative to generate input data for the physics informed data-driven processing technique, including a determination of measurements that are reliable for being processed by the physics informed data-driven processing technique. Measurements that do not reflect the physical process embedded in the physics informed data-driven processing technique may be removed, i.e., are not used for generating the input data for the physics informed data-driven processing technique. Robustness and accuracy are enhanced thereby.

The processing system may comprise or may be an alert and/or alarm generation system operative to generate an alert and/or alarm based on the determination. The processing system may comprise or may be a control system operative to perform a control action (e.g., a control action affecting primary electric power system equipment) based on the determination.

The processing system may be operative to perform the method of any aspect or embodiment disclosed herein. The processing system may comprise or may be communicatively coupled to a storage system having stored therein parameters of the data-driven processing technique. The processing system may be operative to provide the output via the at least one interface.

An electric power system comprises an asset, measurement instrumentation operative to obtain measurements for several different measurement locations at or in proximity to the asset, and the processing system according to an aspect or embodiment operative to process data acquired using the measurements.

Thereby, the technical effects of the processing system and method discussed herein are used for enhanced asset monitoring and/or control for the electric power system.

The electric power system may comprise an electric power generation, transmission, and/or distribution system.

Thereby, the technical effects of the processing system and method discussed herein are used for enhanced asset monitoring and/or control in systems in which conventional processing techniques have shortcomings.

The electric power system may comprise an electric power transmission and/or distribution grid.

Thereby, the technical effects of the processing system and method discussed herein are used for enhanced asset monitoring and/or control in systems in which conventional processing techniques have shortcomings.

The electric power system may comprise a high voltage direct current (HVDC) system. The electric power system may comprise a an inverter/converter comprising insulated gate bipolar transistor (IGBT)- or thyristor-based valves.

Thereby, the technical effects of the processing system and method discussed herein are used for enhanced asset monitoring and/or control in systems in which conventional processing techniques have shortcomings.

According to further embodiments, there is provided machine-readable instruction code which, when executed by at least one programmable circuit, causes the at least one programmable circuit to perform the processing method, the control method, or the operation method according to any aspect or embodiment disclosed herein.

According to further embodiments, there is provided a non-transitory storage medium having stored thereon machine-readable instruction code which, when executed by at least one programmable circuit, causes the at least one programmable circuit to perform the processing method, the control method, or the operation method according to any aspect or embodiment disclosed herein.

Various effects and advantages are attained by embodiments of the invention. For illustration, the processing systems and methods according to embodiments provide enhanced techniques useful in association with asset monitoring and/or electric power system control. The processing systems and methods apply a preprocessing to measurements obtained on an asset and generate input data for a physics informed data driven processing technique based on an identification of measurements that are indicative of a physical process (such as a diffusion process) embedded in the physics informed data driven processing technique.

The processing system and method are operative to determine heat and/or temperature in a spatiotemporally resolved manner along at least several sidewalls of an asset tank, taking into consideration thermal diffusion. The identification of local losses in an asset is facilitated thereby.

The processing system and method can be used in association with an electric power grid or subsystems thereof, without being limited thereto.

BRIEF DESCRIPTION OF THE DRAWINGS

Embodiments of the invention will be described with reference to the drawings in which similar or identical reference signs designate elements with similar or identical configuration and/or function.

Figure 1 is a schematic view of a system comprising a processing system.

Figure 2 is a schematic representation of processing performed by the processing system.

Figure 3 is a schematic representation of processing performed by the processing system.

Figure 4 is a flow chart of a method.

Figure 5 shows measurements processed by the processing system.

Figure 6 shows results of a preprocessing operation performed by the processing system.

Figure 7 shows results of a further preprocessing operation performed by the processing system.

Figure 8 shows an enlarged portion of Figure 7 to explain yet a further preprocessing operation performed by the processing system.

Figure 9 shows a detail of Figure 8 on an enlarged scale.

Figure 10 shows another detail of Figure 8 on an enlarged scale.

Figure 11 shows a result of a further preprocessing operation performed by the processing system.

Figure 12 is a flow chart of a method.

Figure 13 is a flow chart of a method.

Figure 14 is a schematic representation of a PIML model that may be implemented by the processing system.

Figure 15 is a schematic representation of a PIML model that may be implemented by the processing system.

Figure 16 shows a spatial variation of a difference between PIML model and ground truth for different PIML model implementations.

Figure 17 is a flow chart of a method.

Figure 18 is a flow chart of a method.

Figure 19 is a schematic representation of a system that comprises a computing system operative to provide a PIML model for use during inference.

Figure 20 is a flow chart of a method.

Figure 21 is a flow chart of a method.

Figure 22 shows a deviation of PIML model output from ground truth for several implementations of a history-aware PIML model training and a PIML model training that is not history aware.

Figure 23 shows a deviation of PIML model output from ground truth for several implementations of a history-aware PIML model training, with the number of past time instances that is considered being different for the various curves.

Figure 24 is a flow chart of a method.

Figure 25 is a flow chart of a method.

Figure 26 shows results of a heat output by the PIML model as compared to heat determined using a simulation tool for various locations on a tank wall.

Figure 27 shows arrangement of the various locations for which data are provided in Figure 26, with the various locations being arranged on a strip of the tank wall.

Figure 28 shows a mean square error of temperature output by the PIML model as a function of training epochs.

Figure 29 is a flow chart of a method.

Figure 30 is a schematic representation of a further system comprising the processing system.

Figure 31 is a schematic representation of a further system comprising the processing system.

Figure 32 is a schematic representation of a further system comprising the processing system.

Figure 33 is a schematic representation of a further system comprising the processing system.

Figure 34 is a schematic representation of a further system comprising the processing system.

Figure 35 is a schematic representation of a further system comprising the processing system.

## DETAILED DESCRIPTION OF EMBODIMENTS

Embodiments of the invention will be described with reference to the drawings. In the drawings, similar or identical reference signs designate elements with similar or identical configuration and/or function.

Embodiments relate to processing systems and methods operative to determine one or several parameters of an asset of an electric power system in a spatially resolved manner, optionally in a spatiotemporally resolved manner.

The processing systems and methods are operative to perform a physics informed data-driven processing technique, i.e., a processing technique that has knowledge of a physical relationship embedded therein, to determine the parameter(s). The data-driven processing technique may comprise a physics informed machine learning (PIML) model, such as a physics informed neural network (PINN). The PIML model may have an output operative to provide the parameter(s). The PIML model may have an input operative to receive input data that include a location and, optionally, time for which the parameter(s) are to be determined, measurements (such as thermal measurements) for locations for which measurements are deemed reliable and/or at least one operating parameter (such as a load power and/or load current).

While embodiments will be described in detail primarily in association an electric power system that comprises a power transmission and/or power distribution system, the embodiments are not limited thereto.

Processing methods and systems disclosed herein are operative to process measurements obtained for an asset that has a tank, such as a transformer or shunt reactor comprising a tank that may be filled with an insulation fluid (e.g., an insulation oil). The physics informed data-driven processing technique may be operative to process measurements obtained at least on one or several sidewalls of the tank. The physics informed data-driven processing technique may be operative to determine temperature and/or heat in a spatially resolved, optionally a spatiotemporally resolved, manner. The processing system may then be operative to generate output based on the determined spatially resolved temperature and/or heat.

As used herein, the term "electric power system" encompasses an electric power generation, transmission, and/or distribution system, e.g., an electric power grid or parts thereof.

As used herein, the term "power grid" encompasses a power transmission grid and/or a power distribution grid. The power grid may comprise both a power transmission grid and a power distribution grid.

A physics informed data-driven processing technique that is operable to determine at least one parameter may be operative to provide, as an output, the at least one parameter in a spatially resolved manner. The physics informed data-driven processing technique may be operative to provide, as output, a first parameter and a second parameter in a spatially resolved manner (optionally a spatiotemporally resolved manner), wherein the first and second parameters are related to each other by a physical relationship (such as a diffusion equation, e.g., a thermal diffusion equation) that is embedded in the physics informed data-driven processing technique. The physics informed data-driven processing technique may have an input operative to receive input data indicative of one or several positions (e.g., on a tank wall of the asset), a measurement of the first parameter if available for the respective position(s), and at least one operating parameter that affects the second parameter.

As used herein, an "operating parameter" that may be received at an input of the physics informed data-driven processing technique (e.g., at a PIML model input) may be any operating parameter that influences the parameter(s) determined using the data-driven processing technique. For illustration, load power or load current are examples of operating parameters that are useful when applying the techniques disclosed herein for temperature-based asset monitoring applications operable to identify local losses and trigger appropriate action responsive thereto.

The techniques disclosed herein are operative to perform a preprocessing for converting data received by the processing system into input data suitable to be input to the physics informed data driven processing technique. The preprocessing comprises a determination which measurements are reliable, with the input data being generated based on the measurements determined to be reliable and independently of measurements not determined to be reliable.

As used herein, measurements are determined to be "reliable" or measurement locations are determined to provide "reliable" measurements when the measurements can reflect the physical relationship embedded in the physics informed data-driven processing technique. In other words, measurements or measurement locations are deemed to be "reliable" when they do not exhibit behavior that contradicts the physical relationship embedded in the physics informed data-driven processing technique. For illustration, the physics informed data driven processing technique may be operative to determine several parameters related to each other by means of a diffusion equation (e.g., a thermal diffusion equation). In this case, measurements of a first parameter (such as temperature) can be identified as being "unreliable" where a first derivative exhibits a discontinuity (in which case the second derivative in the diffusion equation would be ill-defined or divergent, which is an anomaly). Such measurements determined to be "not reliable" are not indicative of incorrect temperature measurements, but rather indicate that the measurements cannot be relied upon for generating input data for the physics informed data-driven processing technique.

Examples for such measurements that are not suitable for generating the input data for the physics informed data-driven processing technique may include measurements at locations at which structural components of a tank and/or electrical and/or mechanical components within an interior of the tank wall act as heat sinks and/or thermal radiation attenuator(s) that cause thermal measurements to not reflect thermodynamics (such as thermal diffusion) in the asset.

The preprocessing may comprise a transformation of thermal camera output to map pixel coordinates to world coordinates of an asset coordinate frame.

The preprocessing may comprise using a separate mesh for structural components (such as pillars) of a tank of the asset where the measurements are not reliable. The preprocessing may alternatively or additionally comprise edge detection, e.g., for parts at which the measurements are not reliable or redundant.

The preprocessing may comprise removing pixels near boundaries of strips and an interpolation or extrapolation to ensure continuity in heat diffusion.

The physics informed data-driven processing technique may be trained using measurements obtained on a same asset as the one on which the physics informed data-driven processing technique is applied during inference and/or another asset having a similar construction (e.g., another transformer having a tank wall when the asset is a transformer having a tank wall).

The physics informed data-driven processing technique may be trained using a causal training that penalizes high training loss in any past instant. Alternatively or additionally, a temporal gradient regularization may be used in the training, penalizing a high loss and low derivative (e.g., low gradient along the time axis) of the loss function.

The physics informed data-driven processing technique may be validated using measurements of a first parameter (such as spatially resolved temperature measurements) for which such measurements are obtainable and simulation results for a second parameter for which no measurements are available but which is also determined by the physics informed data-driven processing technique (such as heat). To perform such a validation, a computing system that performs the validation may be operative to interface with a simulation system (such as a Python-MATLAB-COMSOL based simulation system).

Various effects and advantages are associated with the processing methods and systems. For illustration, the processing systems and methods may be operative to provide parameter values that have enhanced robustness as compared to conventional techniques.

The processing systems and methods may be operative to utilize PIML. PIML is an emerging area in Machine Learning (ML), where underlying physics of a system is estimated in association with the observed data, making the trained model less dependent on data since it learns to predict from the dynamics directly, compared to purely data-driven processes. The neural networks (NNs) (such as deep or shallow NN) that may be trained to estimate the dynamics along with the observed variables are called Physics-Informed Neural Networks (PINNs) and they can be used to determine parameters by learning from a fully known dynamics (forward problem) or estimating unknown or uncertain components of a partially known dynamics (inverse problem). Due to its capability of estimating dynamics using limited observations, PINNs can be leveraged to estimate the dynamics in complex devices, where the dynamics is partially known, simulation is difficult or impossible due to lack of knowledge of the physical model or data measurements are costly.

The processing systems and methods address the challenge that in some real-life applications, data availability as obtainable by measurements may be limited and/or the quality of the data may not be sufficiently good. An example is the influence of structural components of an asset tank (such as tank reinforcements) on temperature measurements. The processing systems and methods provide techniques in which a PIML model (e.g., a PINN) can be used to estimate thermal diffusion in complex electromagnetic devices such as a power transformers or a shunt reactor in the presence of limited and/or unreliable measurements. To that end, the processing systems and methods are operative to perform a preprocessing to generate input to a PIML model.

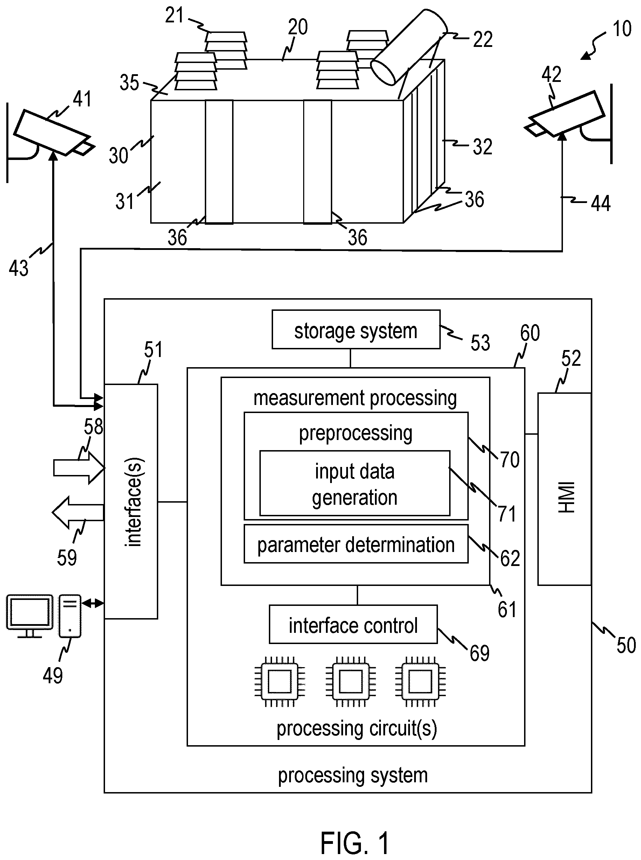

Figure 1 shows a schematic representation of a system 10. The system 10 comprises an asset 20 of an electric power system, measurement instrumentation 41, 42, and a processing system 50 operative to process the measurements. The processing system 50 is operative to perform a physics informed data-driven processing technique to determine one or several parameters, such as temperature and heat, in a spatially resolved manner, optionally a spatiotemporally resolved manner.

The asset 20 has a tank 30. The tank 30 has a plurality of sidewalls 31, 32, a cover 35, and a bottom (which is hidden from view in Figure 1). The asset 20 may have structural components such as tank reinforcements 36 disposed along at least parts of the tank wall. The structural components may reduce the significance of thermal measurements at the locations at which the structural components are provided and in adjacent regions of the tank wall. The asset 20 may have accessory components such as bushings 21 and an expansion tank 22. The tank 20 may be filled with an insulation liquid, such as an insulation oil. The expansion tank 22 may be operative to receive oil from the tank 20 with which it is fluidically connected. Thereby, it can be ensured that a sufficient amount of oil is present within the tank 20 even as the density of the oil varies due to thermal influences.

The measurement instrumentation may comprise one or several sensors operative to sense temperature at a plurality of locations at the tank wall of the tank 30. The measurement instrumentation may be operative to sense temperature or quantities indicative of the temperature in a spatially resolved manner for at least two sidewalls 31, 32 and, optionally, the cover 35. The measurement instrumentation may comprise at least one thermal camera 41, 42. The measurement instrumentation may comprise one or several of thermal cameras 41, 42 operative to perform measurements on at least two sidewalls 31, 32 of the tank 30. The measurement instrumentation may additionally or alternatively comprise other sensors, such as optical of fiber optical sensors operative to measure temperature, thermocouples, or other temperature sensing equipment.

The processing system 50 comprises at least one interface 51. The at least one interface 51 is operative to receive data based on the measurements captured by the measurement instrumentation. The at least one interface 51 may be communicatively interfaced with the measurement instrumentation over at least one communication link 43, 44. The at least one communication link 43, 44 may be a unidirectional or bidirectional communication link. In the latter case, the processing system 50 may be operative to control the measurement instrumentation to perform the measurements.

Generally, the at least one interface 51 of the processing system 50 may be operative to receive data 58 comprising or otherwise based on the measurements. The data 58 may optionally also comprise at least one operating parameter for the asset 20, such as a load current and/or load power. The at least one interface 51 of the processing system 50 may be operative to provide output 59. The output 59 may be based at least on the determined one or several parameters.

The processing system 50 generally comprises one or several processing circuits 60 and the at least one interface 51. The processing system 50 may optionally comprise a human machine interface (HMI) 52. The processing system 60 may comprise a storage system 53 or may be communicatively coupled to the storage system 53. The storage system 53 may have stored therein parameters and, optionally, hyperparameters of a physics informed data-driven processing technique performed by the processing system 50. The parameters and, optionally, hyperparameters may define a PIML model, such as a PINN operative to determine the at least one parameter in a spatially resolved manner. The at least one processing circuit 60 may be operative to retrieve the parameters and, optionally, hyperparameters from the storage system 53. The parameters and, optionally, hyperparameters stored in the storage system 53 may be determined in a training. The training may be implemented in such a manner that a physical relationship is encoded in the trained data driven processing technique. Thereby, the processing system 50 is operative to apply a physics informed data-driven processing technique in a manner which provides physically reasonable solutions (such as spatiotemporal solutions for temperature and heat that take into account a thermal diffusion equation) for a first parameter (e.g., temperature) and a second parameter (e.g., heat), with input data for the physics informed data-driven processing technique being generated based on measurements of the first parameter (and without requiring measurements of the second parameter), using a preprocessing that takes into account whether the measurements of the first parameter can represent the physical behavior embedded in the physics informed data-driven processing technique. Measurement locations for which the measurements cannot represent the physical relationship, e.g., due to second spatial derivative being divergent and/or ill-defined, may be discarded for generating the input data.

The at least one processing circuit 60 is operative to perform a measurement processing 61. The measurement processing 61 may comprise a preprocessing 70. The preprocessing 70 may be operative to transform measurements obtained by the measurement instrumentation 41, 42 into a desired coordinate system (such as a coordinate system fixed to the sidewalls 31, 32 of the tank 30). The preprocessing 70 comprises an input data generation 71 operative to generate input data for the physics informed data-driven processing technique. The input data generation 71 may comprise identifying which measurements are reliable in the sense that they can represent the physical relationship embedded in the physics informed data-driven processing technique. The preprocessing 70 may crop measurement regions in which the measurements are expected to have low reliability, such as measurements in regions of the structural components 36, which can be identified in that they are bounded by a line at which a spatial derivative of temperature exhibits a discontinuity (in which case the second derivative is ill-defined or divergent).

The at least one processing circuit 60 is operative to perform a determination 62 of at least one parameter. The at least one processing circuits 60 may be operative such that the determination 62 determines both heat and temperature in a spatially resolved manner, optionally in a spatiotemporally resolved manner.

The at least one processing circuit 60 may be operative to perform an interface control 69. The interface control 69 is operative to control the at least one interface 51 and/or the HMI 52 to provide output that is based on the determined at least one parameter.

To perform the stated operations, the at least one processing circuit 60 may comprise any one or any combination of integrated circuits, integrated semiconductor circuits, processors, controllers, application specific integrated circuits (ASICs), field programmable gate arrays (FPGAs), circuit(s) including quantum bits (qubits) and/or quantum gates, without being limited thereto.

The determined at least one parameter, which may be spatially resolved over at least a portion of the sidewalls 31, 32 of the tank 30, may be used in various ways to generate the output. For illustration, the at least one parameter may be used to identify in which spatial zones on the tank 30 the heat and/or temperature determined using the physics informed data-driven processing technique is indicative of a local loss in the asset. Alternatively or additionally, the at least one parameter may be used tool determine whether an identified local increase in heat and/or temperature is such that it warrants a control action to be automatically taken and/or a warning, alert, or alarm to be output.

The at least one interface control 69 may, thus, be operative to control the at least one interface 51 and/or the HMI 52 to provide the output that is dependent determined at least one parameter.

The output 59 may comprise control commands or other control data that trigger an action affecting a primary system of the electric power system comprising the asset 20. The processing system 50 may be operative to directly generate and provide control commands. Alternatively or additionally, the processing system 50 may be communicatively interfaced with a control system 49 of the electric power system. The processing system 50 may be operative to generate the output 59 such that it causes the control system 49 to perform an action that affects primary system equipment of the electric power system.

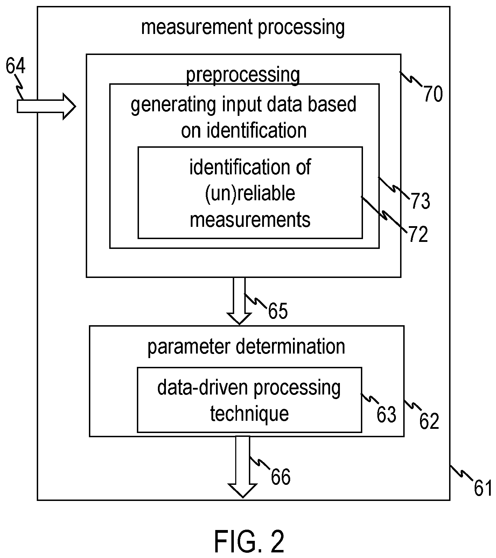

Figure 2 is a schematic block diagram representation of the measurement processing 61. The preprocessing 70 receives input 64 that is based at least on the measurements obtained using the measurement instrumentation. The input 64 may include temperature measurements for a plurality of locations on the tank wall of the tank 30. The preprocessing 70 may perform one or several operations to generate PIML model input 65 based on the input 64. The preprocessing 70 may comprise an identification 72 of reliable and/or unreliable measurements. The identification 72 may comprise one or several of a segmentation to identify structural components of the tank wall, which have the potential of rendering thermal measurements unreliable. The identification 72 may be performed based on the spatially resolved temperature measurements. For illustration, discontinuities of a first spatial derivative of the spatially resolved temperature measurements may be indicative that, at the location at which the discontinuity is detected, there may be a structural component of the tank wall and/or a component within the tank wall that has the effect that the measurements are not indicative of thermal diffusion (e.g., due to the presence of a heat sink and/or thermal radiation attenuator). The preprocessing 70 comprises a generation 73 of input data based on the identification. The generation 73 of the input data may comprise removing measurements that are deemed to be unreliable (for example due to the presence of structural components of the tank 30), and/or performing operations such as extrapolation, interpolation, or regression to replace measurements that can be identified as being unreliable by substitute data that may be updated from adjacent regions in which the thermal measurements are more reliable.

The determination 62 of the at least one parameter comprise processing the input data 65 using a physics informed data-driven processing technique 63. The physics informed data-driven processing technique may comprise a PIML model, such as a PINN. As will be described in more detail below, the physics informed data-driven processing technique 63 is operative in such a manner that it determines at least one parameter (such as temperature and/or heat) in a spatially resolved manner.

The determination 62 is operative to provide, e.g. as an output of the PIML model, the at least one parameter 66. The at least one parameter 66 may be respectively provided for each one of a plurality of locations on at least 2 sidewalls 31, 32 of the tank 30, optionally for a plurality of points in time.

The processing system 50 may be operative to use the PIML model to determine the at least one parameter.

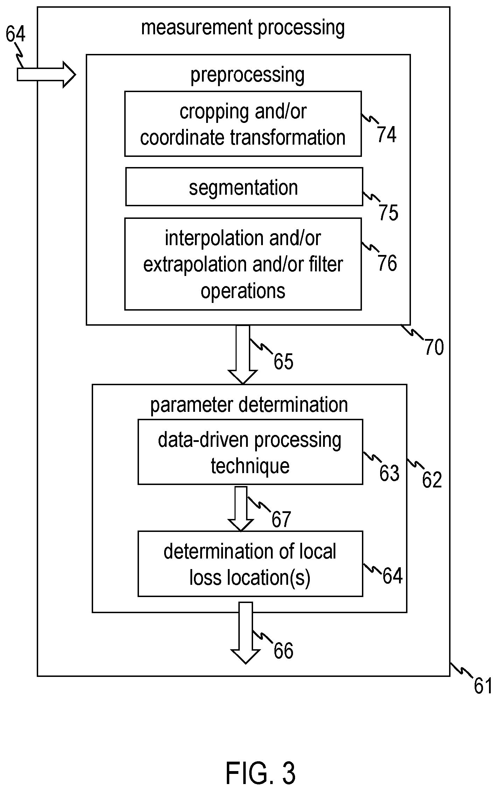

Figure 3 is a schematic representation of a measurement processing 61 that may be performed by the at least one processing circuit 60 of the processing system 50. The measurement processing 61 comprises the preprocessing 70. The preprocessing 70 may comprise a cropping and/or coordinate transformation 74 of measurement data. For illustration, when using thermal cameras, the preprocessing may comprise a cropping 74 that removes pixels or voxels not representative of any portion of the tank 30 and/or a coordinate transformation 74 that transforms the thermal image to a coordinate frame affixed to one or several sidewalls 31, 32 of the tank 30.

The preprocessing 70 may comprise a segmentation 75. The segmentation 75 may be performed based on the thermal measurements. The segmentation 75 may comprise identifying, based on the measurements, pixels or voxels arranged at structural components of the tank 30 that reduce reliability of the thermal measurements in the sense that the thermal measurements are not indicative of the diffusion processes (e.g., the thermal diffusion) embedded in the physics informed data-driven processing technique 63.

The preprocessing 70 may comprise an interpolation, extrapolation, and/or other filter operation 76. The interpolation, extrapolation, and/or other filter operation is preferably local in the sense that only pixels in a local environment of the pixel that is replaced by an interpolated, extrapolated or other filter value are taking into consideration. Thereby, the local association of measurements and locations on the tank 30 remains available during the subsequent processing using the physics informed data-driven processing technique 63.

The output 67 of the physics informed data-driven processing technique 63 may be processed to generate the output 66, with the output 66 being operative to trigger an action (such as an output or automatic control action). For illustration, the output 67 of the physics informed data-driven processing technique 63 may provide temperature and/or heat in a spatially resolved manner, optionally a spatiotemporally resolved manner. Determining at least one parameter may comprise a determination 64 of locations at which the asset exhibits local losses and/or magnitudes of the local losses, as indicated by the heat. The output 66 may be dependent on such an identification of local losses.

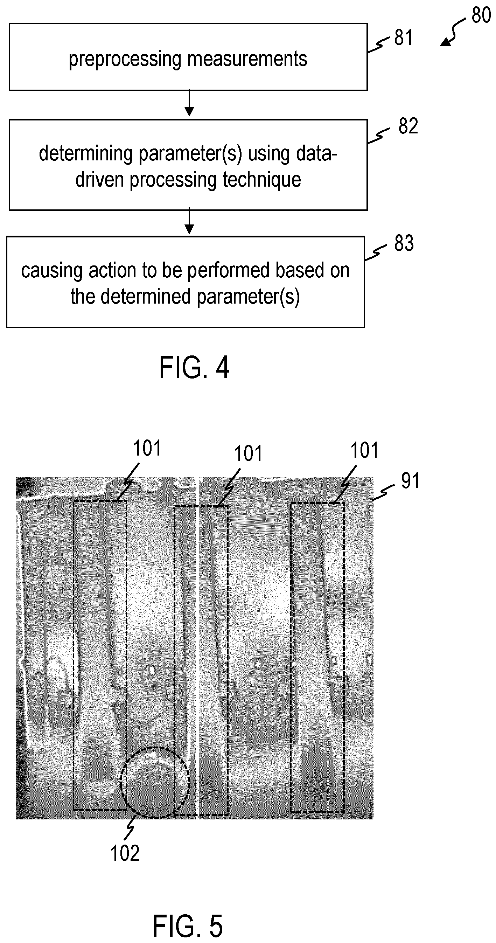

Figure 4 is a flow chart of a method 80. The method 80 may be performed automatically by the processing system 50.

At process block 81, measurements are preprocessed. Preprocessing of the measurements may comprise converting the measurements into a format suitable for provision as input data to a PIML model. Preprocessing comprises identifying reliable measurements and using the reliable measurements to generate input data for processing by a physics informed data-driven processing technique. Identifying reliable measurements may comprise identifying measurement locations at which the measurements have partial spatial and/or temporal derivatives that are not inconsistent with the physical relationship embedded in the physics informed data-driven processing technique. Identifying reliable measurements may comprise identifying measurement locations at which the measurements have first order partial spatial and/or temporal derivatives that do not exhibit discontinuities. Preprocessing may comprise segmentation and/or cropping of thermal images. Preprocessing may comprise an identification of areas in which thermal measurements are unreliable, due to, for example, the presence of structural components of the tank 30 that provide heat sinks and/or thermal shielding. Preprocessing may comprise interpolation or extrapolation to facilitate the subsequent processing by the PIML model.

At process block 82, at least one parameter is determined using the physics informed data-driven processing technique. The at least one parameter may be determined in a spatially resolved manner, optionally in a spatiotemporally resolved manner, for a plurality of locations on, e.g., sidewalls 31, 32 of the tank 30.

At process block 83, the processing system causes at least one action to be performed based on both the determined at least one parameter. Causing at least one action to be performed may comprise triggering a warning, alert, or alarm. Alternatively or additionally, causing the at least one action to be performed may comprise generating a control command or control data that triggers a change in operating conditions, such as a change affecting primary system equipment of the electric power system.

Operation of the processing system will be illustrated further with reference to Figure 5, Figure 6, Figure 7, Figure 8, Figure 9, Figure 10, and Figure 11.

Figure 5 shows measurements 91 comprising a thermal image acquired on a sidewall 31 of a tank 30 of an asset. The arrangement and attitude of the sensor (in this case a thermal camera) relative to the tank 30 causes distortions and may also cause some pixels representing background rather than the sidewall 31. The preprocessing performed by the processing system compensates, at least in parts, such effects that are caused by the arrangement and attitude of the sensor, which may vary. To this end, the preprocessing may comprise cropping and/or coordinate transformation. The measurements 91 also comprise unreliable measurements in regions 101, 102 in which the measurements are unreliable in the sense that the measurements exhibit a behavior (such as discontinuity in a spatial and/or temporal derivative) that is inconsistent with the physical relationship embedded in the data-driven processing technique. The preprocessing identifies such regions and generates the input data for the physics informed data-driven processing technique in such a manner that the input data does not depend on measurements that are inconsistent with the physical relationship embedded in the data-driven processing technique.

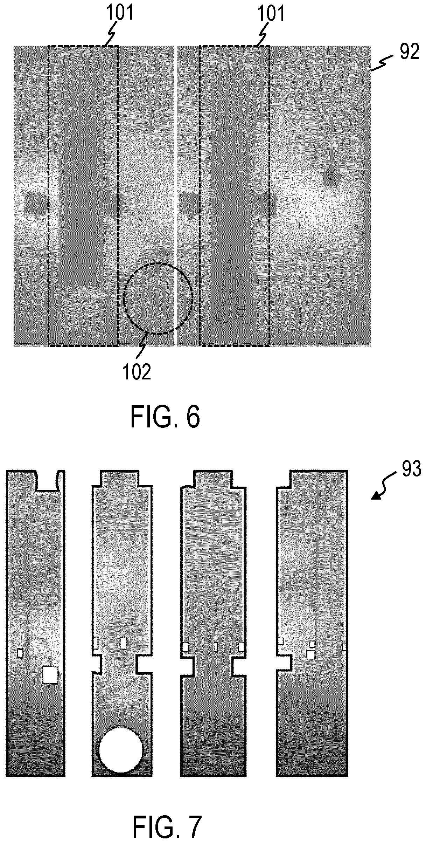

Figure 6 shows the cropped thermal image 92 with a coordinate transformation performed so as to map pixels of the thermal image to associated coordinates on the transformer wall. As seen in Figure 6, there are pronounced temperature drops in certain areas, which are caused by structural components of the tank wall rather than the internal thermal dynamics of the asset. To reduce or eliminate the potential impact of such effects, the preprocessing comprises a segmentation that removes or reduces such regions in which the thermal measurements are inconsistent with the physical relationship embedded in the data-driven processing technique (due to, e.g., the presence of structural components at the tank wall and/or components within the tank that act has heat sink(s) and/or that attenuate thermal radiation).

Figure 7 shows the pre-processed measurements 93 after removal of the regions that are inconsistent with the physical relationship embedded in the data-driven processing technique.

The result of the preprocessing may be made available to the PIML model or another physics informed data-driven processing technique operative to predict at least one parameter or several parameters (such as temperature and heat) in a spatially resolved manner.

The temperature data of Figure 5 can be collected from the asset (e.g., a power transformer or shunt reactor) using various measuring tools, the suitability of which may vary with the accessibility of the component. The measurements may comprise a thermal distribution on the walls of the electrical device captured using a thermal camera and/or thermocouples. The thermal images obtained may be transformed to two-dimensional view to account for errors in translational and rotational shifts in capturing the data (Figure 6). The two-dimensional corrected view may then be further divided into strips by removing the parts that do not reflect the effect of heat diffusion on the surface (Figure 7). When it is not possible to capture a target area of the asset 20 with a single camera shot due to insufficient distance from the object to the camera or due to obstacles, separate measurements from different viewpoints or angles can be performed and processed. Separate measurements are projected into corresponding position in a two-dimensional view so that the entire surface of the measurement target is covered.

Depending on scenario where the temperature measurements are collected, e.g., factory testing or monitoring of operation in the field, there can be measurements captured in thermal images that do not reflect the thermal diffusion process inside the asset. To accommodate this, the preprocessing identifies such pixels and can discard them when generating the input data for the physics informed data-driven processing technique.

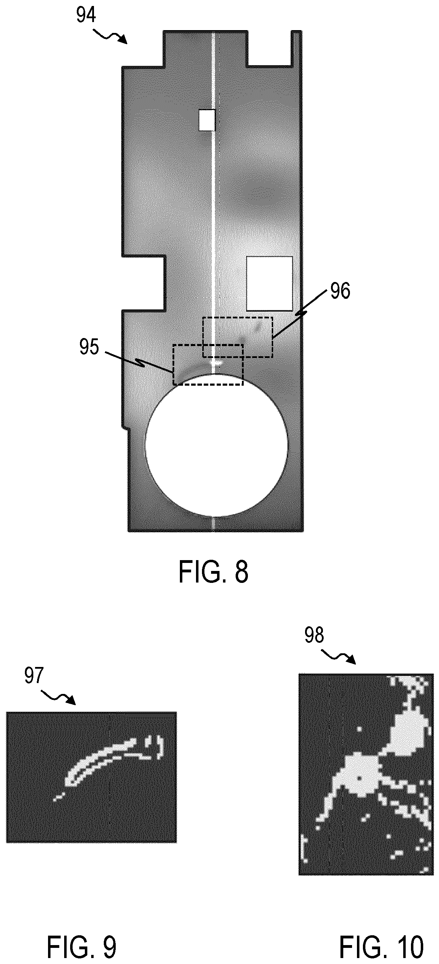

Figure 8, Figure 9, and Figure 10 provide a further illustration of pixels that do not represent thermal diffusion embedded in the physics informed data-driven processing technique. Such identification may be performed using an edge detection technique on the extracted strips. Figure 8 shows an enlarged portion 94 of one of the strips of the cropped and segmented data 93 of Figure 7, and Figure 9 and Figure 10 shows details 97, 98 in regions 95, 96 of Figure 8. Figure 8, Figure 9, and Figure 10 show an example of edge detection using $L_1$-norm of the gradient of the pixels. Interpolation and/or extrapolation may be performed.

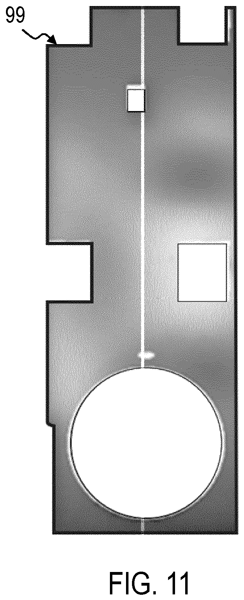

Figure 11 shows interpolated data for the portion 94 of Figure 8, with the interpolation using a cubic spline method after removing the pixels detected as edges.

Thus, the pixels which do not reflect the thermal diffusion can be identified and removed from consideration. The processing system 50 may be operative to control the HMI 52 to enable a user input that specifies which portions are to be discarded when generating the input data for the physics informed data driven processing technique. For a rectangular portion, the processing system 50 may be operative to control the HMI 52 to enable a user input that specifies positions of corners. For a circle or an ellipse, the processing system 50 may be operative to control the HMI 52 to enable a user input that specifies a center position and at least one radius.

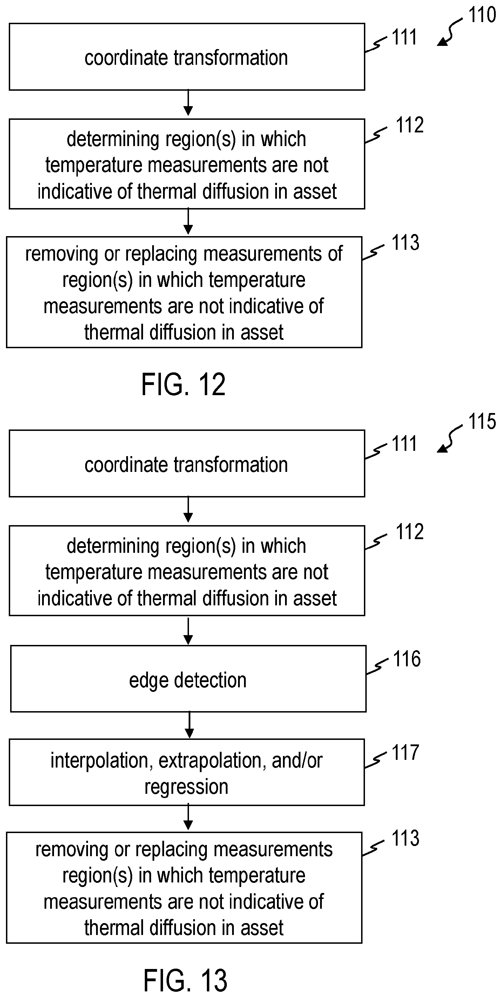

Figure 12 is a flow chart of a method 110. The method 110 may be performed automatically by the processing system 50. The method 110 may be performed to implement the preprocessing at process block 81 of the method 80. The method 110 may be performed to generate input data for a physics informed data-driven processing technique that is operative to provide temperature and heat in a spatially resolved manner (optionally a spatiotemporally resolved manner) and that has been trained with a loss function dependent on a residual of a linear PDE representing thermal diffusion.

At process block 111, a coordinate transform is performed on received measurements. The coordinate transform may comprise a rotation and/or translation. The coordinate transform may be dependent on a position and angular orientation of the measurement instrumentation 41, 42 relative to the asset 20, e.g., relative to the tank 30.

At process block 112, one or several regions are determined in which the measurements are not indicative of thermal diffusion. Determining the one or several regions may be performed based on a spatial gradient of the measurements. Determining the one or several regions may be performed based on an edge detection, which may be based on, e.g., an $L_1$ norm.

At process block 113, the processing system discards or replaces, when generating the input data, the measurements obtained in the one or several regions in which the temperature measurements are not indicative of thermal diffusion.

Discarding may comprise inputting, to the physics informed data-driven processing technique (e.g., to a PIML model input) spatial coordinates that are

- labeled with the temperature if the spatial coordinates are within a region in which the temperature measurements are indicative of thermal diffusion, and
- not labeled with the temperature if the spatial coordinates are within a region in which the temperature measurements are not indicative of thermal diffusion.

Replacing may comprise inputting, to the physics informed data-driven processing technique (e.g., to a PIML model input) spatial coordinates that are labeled with

- a temperature value obtained by measurement if the spatial coordinates are within a region in which the temperature measurements are indicative of thermal diffusion, and
- a temperature value obtained by interpolation or extrapolation from other temperature values if the spatial coordinates are within a region in which the temperature measurements are not indicative of thermal diffusion.

Temperature and/or heat may be determined in a spatially resolved manner in that the processing system 50 is operative to input various spatial coordinates (e.g., on one or several of the sidewalls and/or cover of the tank 30), optionally with temperature labels where available, and at least one operating parameter (such as load current and/or load power) to the data-driven processing technique.

Temperature and/or heat may be determined in a spatiotemporally resolved manner in that the processing system 50 is operative to input various spatial coordinates (e.g., on one or several of the sidewalls and/or cover of the tank 30), optionally with temperature labels where available, and various times and at least one operating parameter (such as load current and/or load power) for the respective time to the data-driven processing technique. Thereby, temperature and heat can be determined in a spatiotemporally resolved manner using the data-driven processing technique.

Figure 13 is a flow chart of a method 115. The method 115 may be performed automatically by the processing system 50. The method 115 may be performed to implement the preprocessing at process block 81 of the method 80. The method 115 may be performed to generate input data for a physics informed data-driven processing technique that is operative to provide temperature and heat in a spatially resolved manner (optionally a spatiotemporally resolved manner) and that has been trained with a loss function dependent on a residual of a linear PDE representing thermal diffusion.

Process blocks 111, 112, and 113 may be implemented as previously explained with reference to Figure 12.

The method 115 may further comprise, at process block 116, an edge detection to determine structures at which temperature measurements are not indicative of thermal diffusion (e.g., along the walls of the tank).

The method 115 may further comprise, at process block 117, an interpolation, extrapolation, and/or application of a local filter kernel at locations determined by the edge detection at process block 116.

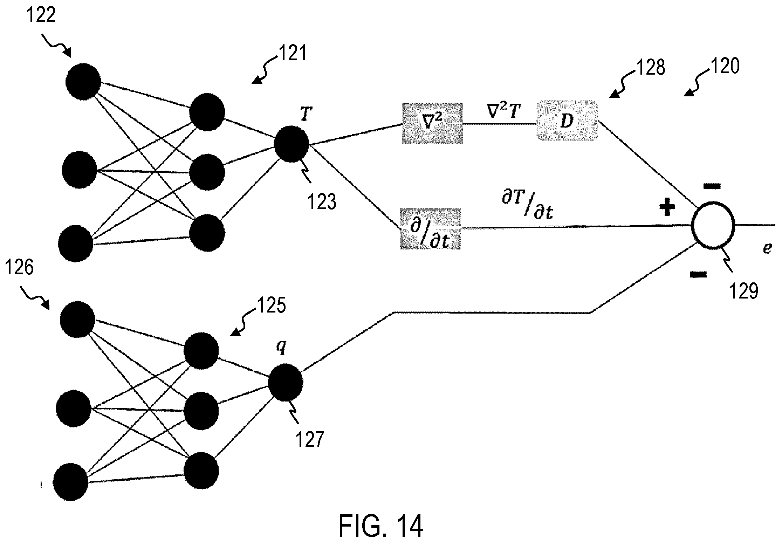

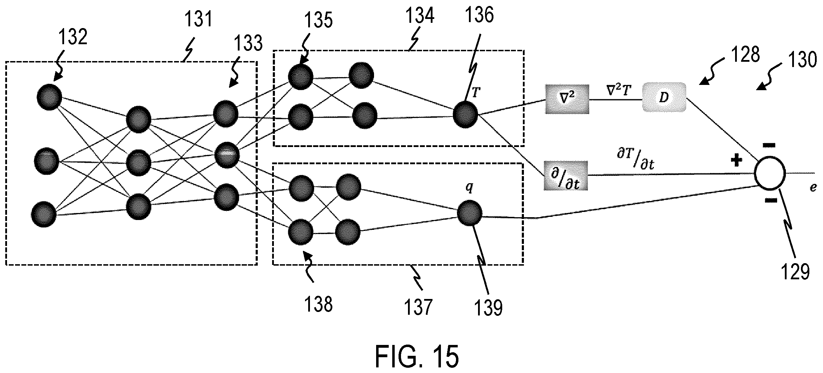

Figure 14 and Figure 15 shows implementations of a physics informed data-driven processing technique realized as a PIML mode, such as a PINN.

Figure 14 is a schematic representation of a PIML model 120. The PIML model 120 has an input 122, 126. The PIML model 120 includes a PIML model 120 portion 121 operative to predict a first parameter (such as temperature). The PIML model 120 may include a further PIML model 120 portion 125 operative to predict a second parameter (such as seed) that is related to the first parameter by virtue of a physical relationship. The PIML model 120 may have an output 123 operative to provide the first parameter. The PIML model 120 may have further output 127 operative to provide the second parameter.

The PIML model 120 is trained in such a manner that it embeds a physical relationship. The physical relationship depends on the first and second parameters. For a thermal diffusion phenomenon, the physical relationship may be a partial differential equation (PDE) that links the first partial time derivative of the temperature, the second partial spatial derivatives of the temperature (such as a 2D or 3D Laplace operator), and the rate of change of heat with each other. This physical relationship embedded in the PIML model 120 is schematically illustrated by means of operators 128 and summation / subtraction node 129. An output of the summation node 129 provides the residual of the PDE. During training, the PIML model 120 is trained using a loss function that includes a term dependent on the PDE residual. Thereby, the first and second PIML model 120 portions 121, 125 are trained to provide physically meaningful solutions that comply with the thermal diffusion equation.

It will be appreciated that, during inference, it is not required (but still possible) to determine the residual of the PDE. In other words, the operations 128, 129 may be omitted when using the PIML model 120 during inference.

The input nodes 122 may be operative to receive spatial coordinates (such as a pair of coordinates specifying a location on the sidewalls 31, 32 of the asset) and time. When available and deemed reliable, temperature for this location and time may be used as a label for the input or may otherwise be provided at the input nodes 122. It should be understood that, while temperature measurements are obtained using the measurement instrumentation, the PIML model 120 provides additional useful information because, firstly, it provides a holistic determination of temperature and heat that complies with thermal diffusion, and, secondly, it can also provide temperature and/or heat in regions in which the measurements are not indicative of heat diffusion.

The input nodes 126 may be operative to receive spatial coordinates and an operating condition that affects temperature and/or heat. For illustration, the input nodes 127 may be operative to receive spatial coordinates (such as a pair of coordinates specifying a location on the sidewalls 31, 32 of the transformer) and a load power and/or load current.

Figure 15 is a schematic representation of a PIML model 130. The PIML model 130 comprises a first plurality of neural network (NN) layers 131 having a first input layer 132 and a first output layer 133. The PIML model 130 comprises a second plurality of NN layers 134 having a second input layer 135 coupled to the first output layer 133. The second plurality of NN layers 134 have an output layer 136 operative to provide a first parameter (e.g., temperature). The PIML model 130 comprises a third plurality of NN layers 137 having a third input layer 138 coupled to the first output layer 133. The third plurality of NN layers 137 have an output layer 139 operative to provide a second parameter (e.g., heat). The PIML model 130 is trained such that the output at output nodes 136, 139 complies with a physical relationship (such as thermal diffusion) embedded in the at least one PIML model (e.g., by using a PIML model that was trained with a loss function dependent on the a residual of a thermal diffusion PDE).

A configuration as explained with reference to Figure 15 provides various technical effects. Training two separate architectures for predicting temperature and heat requires more memory and more training time, which can be significant based on the use case, especially if the required size of each model is large. The PIML model architecture in which there are common NN layers 131 has the effect that some PIML model parameters are shared. The degree of sharing is a hyperparameter that can be based on, e.g., accuracy and time of convergence based on the use case. In Figure 15, the number of layers in each of the portions 131, 134, 137 are hyperparameters that can be optimized during the training. Alternatively or additionally, a number of neurons per layer can be varied.

To further enhance the accuracy attained by the PIML model, the PIML model may have an output layer that enforced positivity of temperature and heat provided at the output. Since the PIML model output in the inverse problem of heat diffusion problem is the temperature (typically in K) and load loss, both of which have non-negative values, the model's output can be enforced to be non-negative by introducing an absolute value as the last layer of the PIML model. This reduces the estimation error.

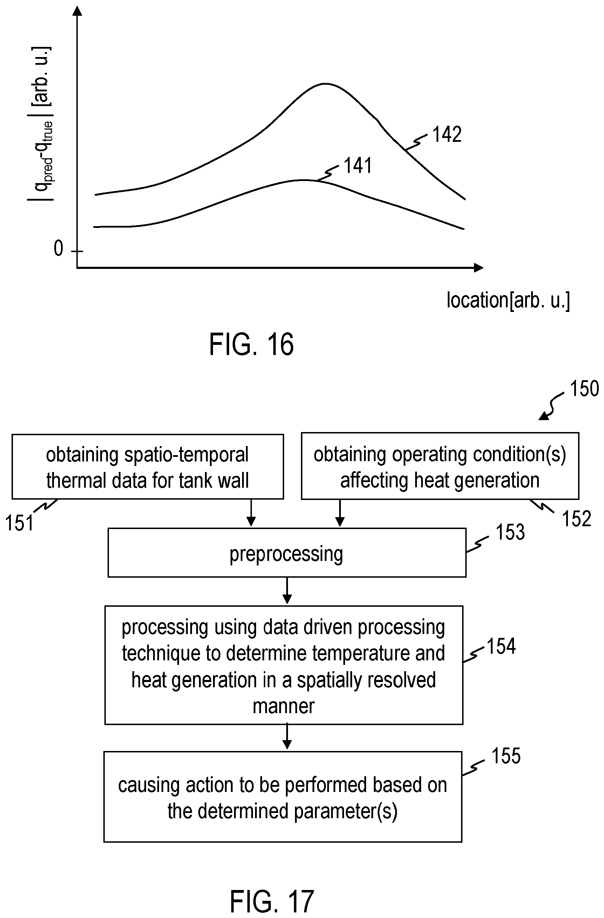

Figure 16 shows this effect for the deviation of heat (load loss) output by the PIML model from the ground truth obtained by simulation (with the ground truth being not used during training). The curves 141, 142 in Figure 16 are taken along a line on the tank wall 30 at which the deviation is maximum. Curve 141 represents the deviation for a PIML model that has an output layer that enforced positivity of temperature and heat. Curve 142 represents the deviation for a PIML model in which positivity is not enforced during training. As can be seen from Figure 16, accuracy is improved by using a PIML model in which the output (temperature in K and heat) is enforced to be non-negative. It is re-emphasized that, in Figure 16, the simulated ground truth values of heat loss, $q_{true}$ is used only for validation and is not used during training.

Figure 17 is a flow chart of a method 150. The method 150 may be performed automatically by the processing system 50.

At process block 151, the processing system obtains spatiotemporally resolved thermal data for a wall of a tank of the asset.

At process block 152, the processing system obtains at least one operating condition that affects heat generation in the asset. Load current and/or load power are examples for such operating conditions.

At process block 153, the processing system performs a preprocessing of the thermal data. Preprocessing may comprise identifying one or several region(s) in which the thermal data are not reliable and generating input data for a physics informed data driven processing technique based on the determination.

At process block 154, the processing system processes the input data to determine temperatures and heat in a spatially resolved manner, optionally in a spatiotemporally resolved manner. The processing system may use a PIML model as explained with reference to Figure 14 or Figure 15 to perform the processing.

At process block 155, the processing system causes at least one action to be performed based on the determined parameters (temperature and/or heat).

The preprocessing disclosed herein may be performed not only during inference but also during training. Thereby, accuracy of the prediction is enhanced. Other aspects useful in association with training, such as using a PIML model that has an output layer that enforced non-negativity of parameter(s) known to be non-negative and/or determining a number of layers and/or neurons per layer as hyperparameters during the training were already explained herein. Further aspects relating to training and/or validation will be described in more detail below. The training may be performed by the processing system 50 or by another computing system that may be communicatively interfaced with the processing system 50 or that may be otherwise operative to provide PIML model data to the processing system 50.

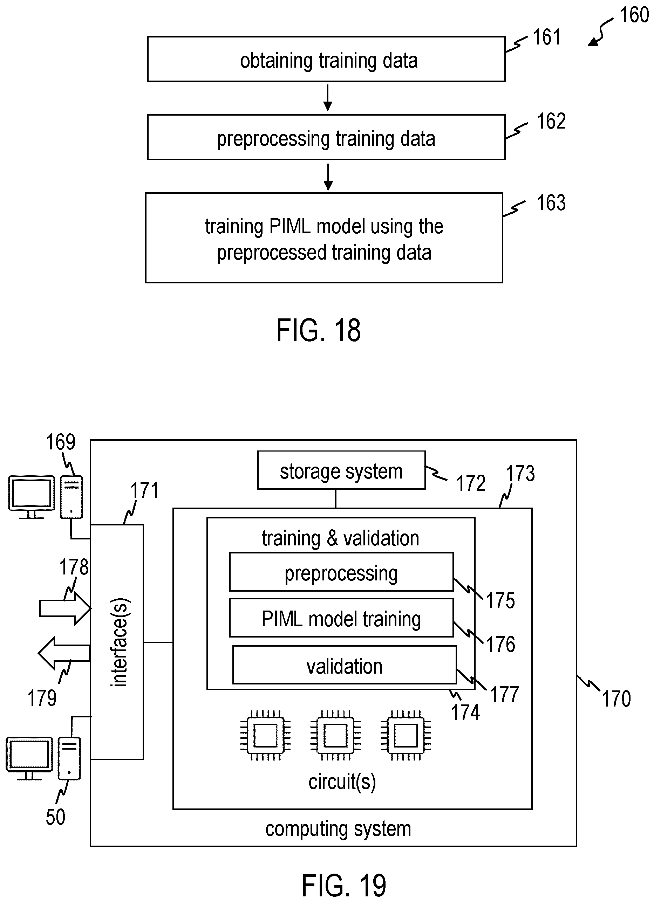

Figure 18 is a flow chart of a method 160 of providing a PIML model for use by the processing system 50. The method 160 may be performed by the processing system 50 or by another computing system.

At process block 161, training data are obtained. The training data may comprise measurements of at least a first parameter (such as temperature) measured on an asset that is identical to or similar or identical in construction to the asset on which the PIML model is to be used.

At process block 162, the training data are preprocessed. Preprocessing the training data may comprise any of the operations explained with reference to Figure 1 to Figure 17 herein. Preprocessing the training data may in particular comprise determining, based on the measurements of the first parameters, in which region(s) the measurements are not indicative of the physical process (such as thermal diffusion) embedded in the PIML model, and replacing or discarding such measurements that are not consistent with this physical process.

At process block 163, the PIML model is trained using the preprocessed training data. Training the PIML model may comprise a training with a loss function that is dependent on an estimation error and a PDE residual. The training may be performed as a history-aware training which is dependent on a derivative of the loss function at a previous training instant or, preferably, at several previous training instants.

Figure 19 is a schematic representation of a system that comprises a computing system 170 operative to provide the PIML model for use by the processing system 50.

The computing system 170 comprises at least one interface 171. The at least one interface 171 is operative to receive training data based on measurements captured by the measurement instrumentation. The at least one interface 171 may be communicatively interfaced with the measurement instrumentation and/or with a data repository that stores the training data.

Generally, the at least one interface 171 of the computing system 170 may be operative to receive input 178 comprising or otherwise based on the measurements. The input 178 may optionally also comprise at least one operating parameter, such as a load current and/or load power. The at least one interface 171 of the computing system 170 may be operative to provide output 179. The output 179 may be based at least on the results of the PIML model training. The output 179 may comprise PIML model parameters and/or hyperparameters for use by the processing system 50.

The computing system 170 generally comprises one or several circuits 173 and the at least one interface 171. The computing system 170 may comprise a storage system 172 or may be communicatively coupled to the storage system 172. The storage system 172 may be used for storing training data and/or parameters, and/or data useful for performing history-aware training (such as loss function values and/or time derivatives of loss functions determined in previous time instances of the training). The storage system 172 may be operative to store parameters and/or hyperparameters of the PIML model as determined by the computing system 170. The parameters and, optionally, hyperparameters may define a PIML model, such as a PINN operative to determine at least one parameter (such as temperature and heat) in a spatially resolved manner.

The at least one circuit 173 is operative to perform a PIML model training and validation 174 based on the input 178. The PIML model training and validation 174 comprises a preprocessing 175. The preprocessing 175 may be implemented using techniques as described with reference to Figure 1 to Figure 18. The preprocessing 175 may comprise identifying which measurements included in the input 178 are reliable in the sense that they can represent the physical relationship embedded in the physics informed data-driven processing technique. The preprocessing 175 may crop measurement regions in which the measurements are expected to have low reliability, such as measurements in regions of the structural components 36, which can be identified in that they are bounded by a line at which a spatial derivative of temperature exhibits a discontinuity (in which case the second derivative is ill-defined or divergent).

The at least one circuit 173 is operative to perform a PIML model training 176. The PIML model training 176 may be performed using a loss function that depends on an estimation error (such as a mean square error) and a PDE residual.

The loss function may be set up in such a manner that the loss function at a time instant is dependent on the loss function, in particular a time derivative of the loss function, at one or preferably several previous time instances.

The at least one circuit 173 is operative to perform a PIML model validation 177. The computing system 170 may be operative to communicatively interface with at least one simulation system 169 to perform the validation. For illustration, when no measurements for ground truth of one of the parameters output by the PIML model is available, the at least one circuit 173 may be operative to provide the spatially varying temperature determined by the PIML model to the at least one simulation system 169 via the at least one interface 171 and to receive, from the at least one interface 171, a simulation result for the ground truth for heat. The simulation result for the ground truth may be used for validation.

To perform the stated operations, the at least one circuit 173 may comprise any one or any combination of integrated circuits, integrated semiconductor circuits, processors, controllers, application specific integrated circuits (ASICs), field programmable gate arrays (FPGAs), circuit(s) including quantum bits (qubits) and/or quantum gates, without being limited thereto.

Training may be performed such that all parameters of the PIML model are trained jointly (or in tandem). However, it has been found out that training can be performed efficiently and accuracy can be enhanced by training portions related to different parameters (such as a portion related to determining temperature and a portion related to determining heat) separately before training them jointly

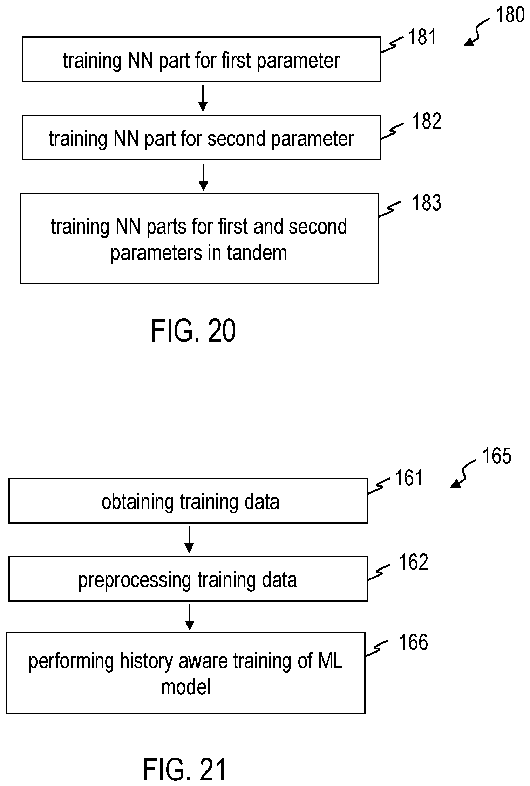

Figure 20 is a flow chart of a method 180 of providing a PIML model. The method 180 may be performed to implement step 163 of the method 160. The method 180 may be performed automatically by the computing system 170.

At process block 181, a first NN part of the PIML model that determines a first parameter (such as temperature) is trained while keeping parameters of a second NN part of the PIML model unchanged, which second NN part determines a second parameter (such as heat).

At process block 182, the second NN part of the PIML model that determines the second parameter (such as heat) is trained while keeping parameters of the first NN part of the PIML model unchanged.

At process block 183, the first and second NN parts are trained in tandem.

For illustration, referring to Figure 14, the training may comprise a training of the first NN part 121 while keeping the parameters of the second NN part 125 fixed, a training of the second NN part 125 while keeping the parameters of the first NN part 121 fixed, followed by training the first NN part 121 and the second NN part 125 in tandem.

For further illustration, referring to Figure 15, the training may comprise a training of the NN parts 131, 134 while keeping the parameters of the NN part 137 fixed, a training of the NN part 131, 137 while keeping the parameters of the NN part 134 fixed, followed by training the NN parts 131, 134, 137 in tandem.

It has been found that the speed of the training is increased significantly by such a technique in which each part is trained separately before training in tandem. For illustration, first the temperature NN can be trained while no update of parameters in the heat NN. This is followed by training the heat NN for some episodes while freezing the updates in the parameters in the temperature NN. Once both NNs are trained so that the transient training errors are reduced, they are then trained together for the rest of the training episodes. The training with NNs pretrained in such a manner show enhanced stability in the beginning of the earlier episodes of the training, which results into faster convergence.

Figure 21 is a flow chart of a method 165 of providing a PIML model for use by the processing system 50. The method 165 may be performed by the processing system 50 or by the computing system 170.

At process block 161, training data are obtained. The training data may comprise measurements of at least a first parameter (such as temperature) measured on an asset that is identical to or similar or identical in construction to the asset on which the PIML model is to be used.

At process block 162, the training data are preprocessed. Preprocessing the training data may comprise any of the operations explained with reference to Figure 1 to Figure 17 herein. Preprocessing the training data may in particular comprise determining, based on the measurements of the first parameters, in which region(s) the measurements are not indicative of the physical process (such as thermal diffusion) embedded in the PIML model, and replacing or discarding such measurements that are not consistent with this physical process.

At process block 165, the PIML model is trained using the preprocessed training data, wherein the training comprises a history-aware training. In the history aware training, previous losses at a previous training instant or at several previous training instants are taken into consideration.

The history aware training provides various technical effects when used in association with the PIML model disclosed herein. Prediction accuracy of the dynamics can be affected by the estimation error in the past, since in a dynamical system, the estimation error may propagate through the underlying PDE. If the estimation error in one or more earlier episodes of the training are considerably high, it also impacts the prediction accuracy of the later episodes, which in turn affects the convergence speed.

One way of forcing the impact of the error from the past to be low is to penalize the past high errors.

In a first implementation of such history-aware training, causal training following S. Wang et al., "Respecting causality is all you need for training physics-informed neural networks", March 14, 2022, arXiv:2203.07404 is applied to penalize all past instants with large loss by introducing an exponential weight to each temporal loss, the weight being a function of all past losses. In practice, this means that for each sample in time the total PINN-loss is defined as follows:

$$\mathcal{L}_{PINN} := \frac{1}{N_t} \sum_{i=1}^{N_t} \omega_i \, \mathcal{L}_{PINN}(t_i), \qquad (1)$$

with $\omega_i$ being the loss weight defined as

$$\omega_i = \exp\left(-\epsilon \sum_{i=1}^{N_{t-1}} \mathcal{L}_{PINN}(t_i)\right). \qquad (2)$$

Such an approach aims at minimizing the loss at time $t_j$ only when all the losses corresponding to previous times has been minimized. This approach has improved significantly the results in forward problems, where the idea is to let the information flow from the known initial condition onward in time.

Since the causal training mentioned above accounts for *all* past losses, this may be computationally heavy when there is a long history. Moreover, depending on the dynamical system, looking at the entire history may not be even necessary, since the recent past captures the more impactful error already propagated through the dynamics.

Thus, in a further implementation, the weights can be a function of the temporal gradient. For illustration, the weight $w_t$ at instant t is dependent on a temporal gradient of the loss function for at least one previous instant and optionally several (n) last instants, e.g.,

$$\omega_i =$$
$$\mathrm{F}(\mathcal{L}_{PINN}\left(t_{N_{t-1-n}}\right); \frac{\partial \mathcal{L}_{PINN}(t_{N_{t-1-n}})}{\partial t}; \mathcal{L}_{PINN}\left(t_{N_{t-n}}\right); \frac{\partial \mathcal{L}_{PINN}(t_{N_{t-n}})}{\partial t}; \dots;$$
$$\mathcal{L}_{PINN}\left(t_{N_{t-1}}\right); \frac{\partial \mathcal{L}_{PINN}(t_{N_{t-1}})}{\partial t}). \qquad (3)$$

The function F may be set up such that it is a monotonously decreasing function of loss at one or several past time instants and a monotonously increasing function of a time derivative of the loss at the one or several past time instants. In other words, the weights may be such that they penalize previous high loss and a small time derivative of the loss.

In one implementation, the weights may be an exponential of a function that is indirectly proportional to the temporal gradient from the last instant and directly proportional to the current loss, as is shown below:

$$\omega_i = \exp\left(-\epsilon \sum_{i=N_{t-1-n}}^{N_{t-1}} \mathcal{L}_{PINN}(t_i) \left|\frac{\partial t}{\partial \mathcal{L}_{PINN}(t_i)}\right|\right), \qquad (4)$$

with the training loss being given by Equation (1).

The history aware training improves accuracy of the PIML model's output.

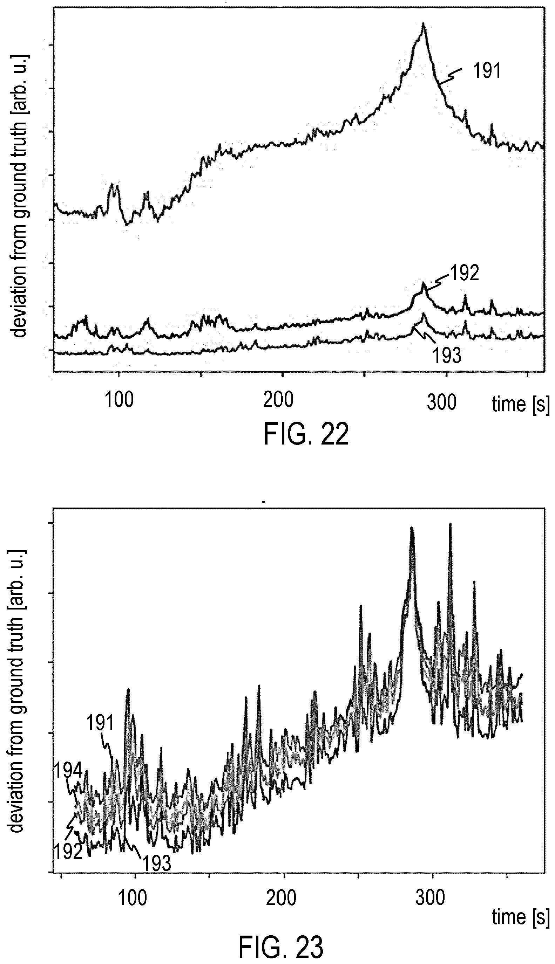

Figure 22 shows the PIML model's accuracy (mean square error, MSE) as a function of time over the time period over which measurements were captured. Curve 191 represents the accuracy when no history-aware training is used. Curve 192 represents the accuracy when a history-aware training in accordance with Equation (2) is used which takes into account all previous instants. Curve 193 represents the accuracy with a history-aware training in accordance with Equation (4) with n=1 is used. Thus, a history-aware training that is dependent on inter alia a time derivative of the loss function at several (but not all) previous time instants provides an improvement over both other techniques 191, 192. History-aware training 192, 193 provides an improvement over non-history aware training 191.

Figure 23 shows the PIML model's accuracy (mean square error, MSE) for history-aware training in accordance with Equation (4), for various values of previous instants taken into account, n. The curves are respectively shown as a function of time over the time period over which measurements were captured. Curve 191 corresponds to n=1, curve 192 corresponds to n=2, curve 193 corresponds to n=10, and curve 194 corresponds to n=100. As seen in Figure 12, a training that considers too long a history (n=100) performs worse than a shorter history (n=10).

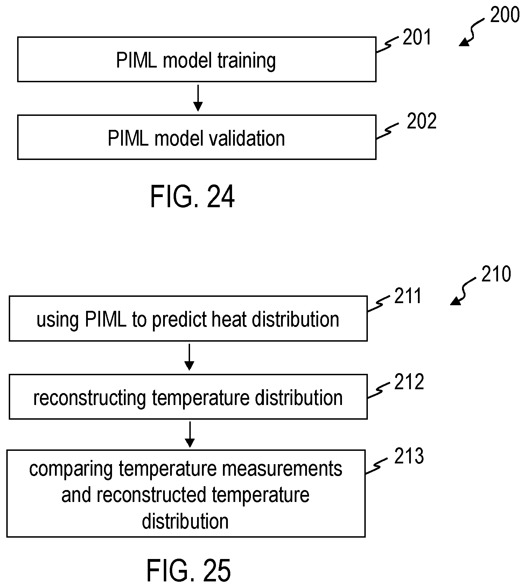

Figure 24 is a flow chart of a method 200 of providing a PIML model for use by the processing system 50. The method 200 may be performed automatically by the computing system 170 or by the processing system 50.

At process block 201, PIML model training is performed. PIML model training may be performed using any one of the techniques described with reference to Figure 18, Figure 19, Figure 20, Figure 21, Figure 22, Figure 23, and Figure 24.

At process block 202, PIML model validation is performed. The PIML model validation may comprise using a first parameter determined by the PIML model in a spatially resolved manner as an input for a simulation technique that provides a second parameter (that is also determined by the PIML model) in a spatially resolved manner. The PIML model validation may comprise a comparison of the spatially resolved PIML model output for the second parameter and the spatially resolved second parameter determined using the simulation technique. Thereby, validation is facilitated in cases in which measurements are not available or not reliable as ground truth for PIML model validation.

Simulation techniques that can be used to simulate physical processes in an asset are commercially available. The COMSOL simulation systems are exemplary for this. Thus, dynamics of asset parameters (such as thermodynamics governed by thermal diffusion) may be modelled for PIML model validation, as explained.

Figure 25 is a flow chart of a method 210 of providing a PIML model for use by the processing system 50. The method 210 may be performed automatically by the computing system 170 or by the processing system 50. The method 210 may be performed to implement the PIML model validation 202.

At process block 211, the PIML model is used to predict a heat distribution. The predicted heat distribution (for which ground truth is often not adequately available from measurements) is made available to a simulation system for reconstructing the temperature distribution.

At process block 212, a reconstruction of the temperature distribution is obtained by performing a simulation, using the heat distribution from the PIML model output as input for the simulation. Simulation tools are available in the art, which can be used to simulate thermodynamics within an asset. The result of the simulation is a reconstruction of the temperature distribution.

At process block 213, the reconstruction of the temperature distribution is compared with measurements of the temperature distribution.

Such a technique of performing PIML model validation addresses the challenge that ground truth values for at least one of the parameters (such as heat) may be difficult to obtain using a conventional measurement instrumentation, when considering the constraints imposed by an asset such as a power transformer. The approach of Figure 25 provides an indirect way of validating the PIML model by using part of the PIML model output (estimated heat function) to reconstruct the temperature distribution using any established physics simulator software (such as COMSOL) and compare the reconstructed temperature with the measured temperature.

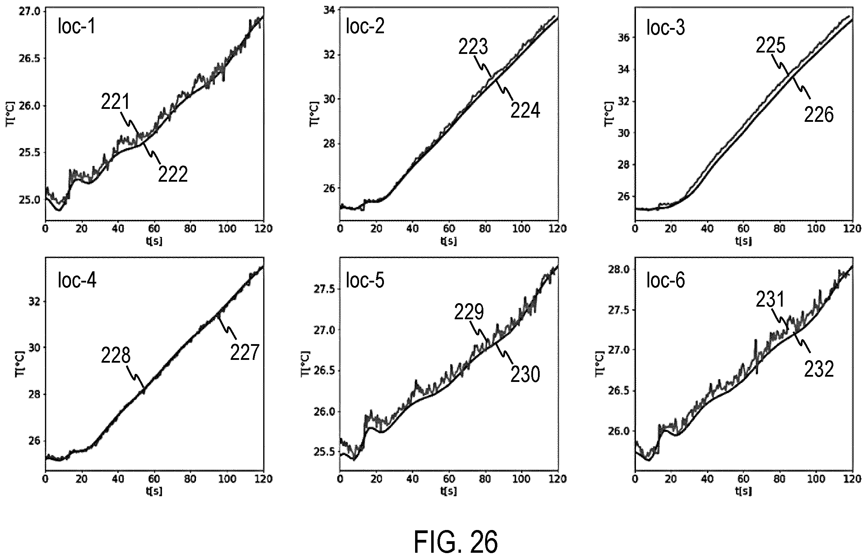

Figure 26 compares the reconstructed temperature (as a function of time) against the measured temperatures at select points on a surface of the transformer wall. In Figure 26, curves 221, 223, 225, 227, 229, and 231 show the measurements. Curves 222, 224, 226, 228, 230, and 232 show the reconstructed temperatures. The location is respectively specified as inset in each of the boxes.

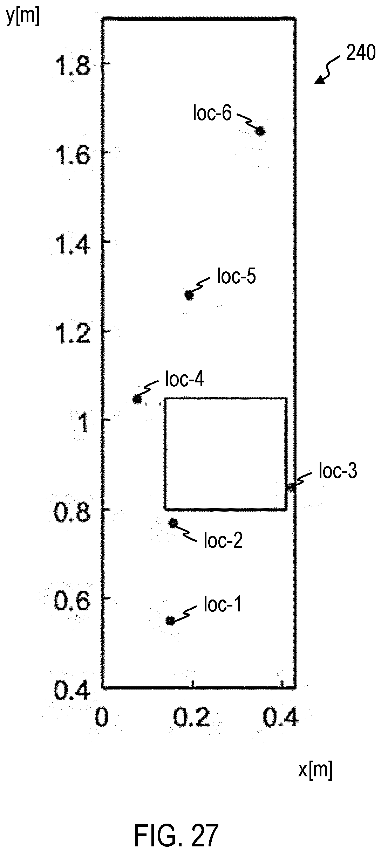

Figure 27 shows the arrangement of the various locations loc-1, loc-2, loc-3, loc-4, loc-5, loc-6 for which the comparison is provided in Figure 26 on a portion of the tank wall 240.

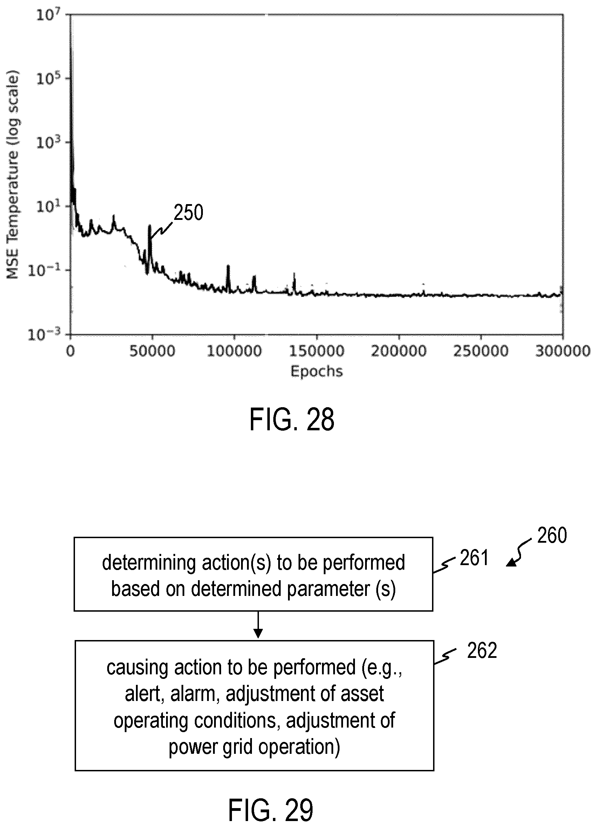

Figure 28 shows a validation mean squared error (MSE) 250 as a function of training epochs.

Thus, as evidenced by the provided data (see, e.g., Figure 26 and Figure 28), good prediction accuracy is attained.

For the data disclosed herein, the training data was captured using a thermal camera with a chip of more than 1000 x 1000 pixels, with a series of 200 images being captured over a time period of several minutes in which the load current was varied. The training data were captured on a power transformer having a tank filled with insulation oil.

The processing system and method may be operative to process measurements captured using a thermal camera. The thermal camera may have a resolution of, e.g., at least $500 \times 500$ pixels, at least $800 \times 800$ pixels, or at least $1000 \times 1000$ pixels. Thermal images may be captured over a time period of several minutes, with at least 50, at least 100, or at least 150 images being captured and processed.

For illustration, the data shown in Figure 22, Figure 23, Figure 26, and Figure 28 were obtained using a thermal camera with more than $1000 \times 1000$ pixels, with more than one 150 images being captured over a period of several minutes and processed.

However, it has surprisingly been formed and demonstrated that the techniques, i.e. the processing system and method, remain operative even when much sparser data is used. To demonstrate this, performance of the PIML model was checked for cases in which only a fraction of the pixels of the thermal camera were used for predicting spatiotemporal variations of temperature and/or heat.

More specifically, the trained PIML model was tested using input that includes measurements for only 1/10 and 1/2000 of the pixels of the thermal camera. As the tests have shown, the performance remains good even in cases of data sparsity in which only a fraction (1/10 and 1/2000 of the pixels) of the pixels of the thermal camera is used for generating the input of the PIML model 80. Thus, the techniques disclosed herein provide robustness on sparsity of data.

The PIML model may be used to generate output that can have various forms.

Figure 29 is a flow chart of a method 260. The method 260 may be performed automatically by the processing system 50 alone or in association with a control system 49 communicatively coupled to the processing system 50.

At process block 261, the processing system 50 determines which action is to be performed based on the at least one determined parameter. The action to be performed may be determined based on spatial and/or temporal variations of the determined at least one parameter. Determining the action to be performed may comprise determining, based on a spatiotemporally varying temperature and/or heat distribution, whether there are unacceptable local losses in the asset.

At process block 262, the action determined at process block 261 is caused to be performed. Causing the action to be performed may comprise any one or any combination of outputting a warning, alert, or an alarm. Causing the action to be performed may alternatively or additionally comprise causing, by the processing system 50 or by the control system 49 communicatively coupled thereto, an operation that affects the primary system of the electric power system that includes the asset 20.

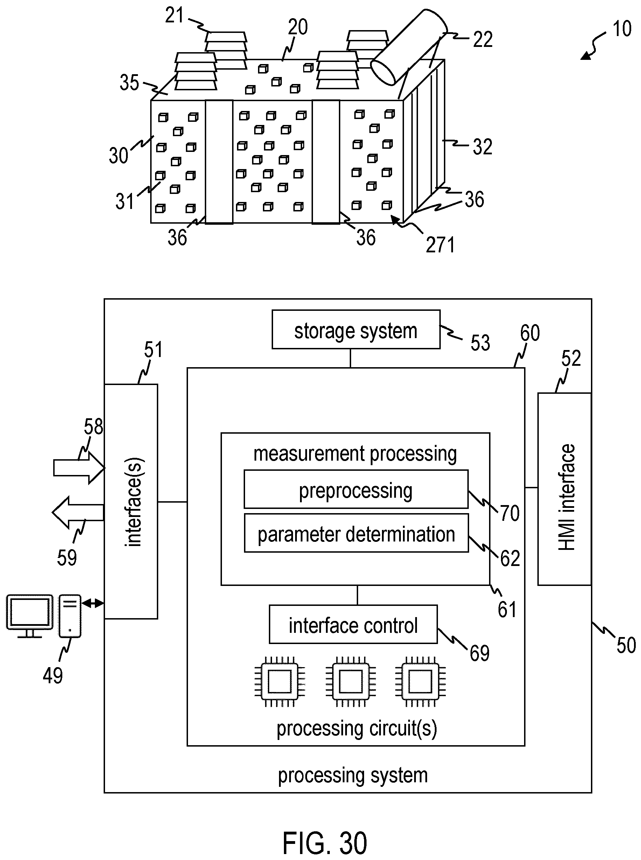

Figure 30 shows a schematic representation of a system 10 according to further embodiments. The system 10 comprises measurement instrumentation including a plurality of sensors 271 (such as thermocouples) arranged and operative to sense temperature at a plurality of locations on one or several sidewalls 31, 32 and/or the cover 35 of the tank 30. The processing system 50 is operative to process data 58 including the measurements captured by the plurality of sensors 271.

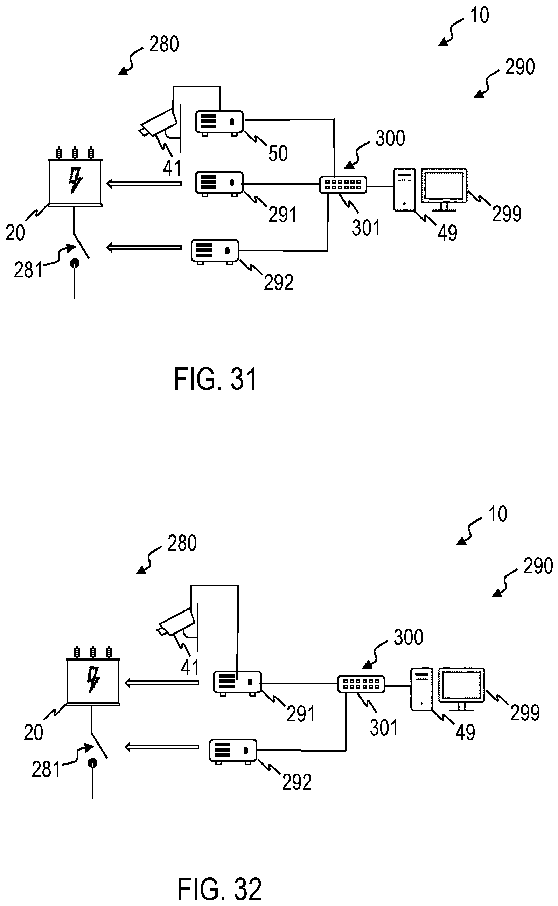

As already explained, the processing system 50 may be operative to trigger an action based on the determined at least one parameter. The processing system 50 may be integrated into or communicatively coupled with an automation control system of an electric power system. Exemplary configurations are explained with reference to Figure 31, Figure 32, Figure 33, Figure 34, and Figure 35.

Figure 31, Figure 32, Figure 33, and Figure 34 respectively show a schematic representation of a system 10 comprising an electric power system. The electric power system comprises a primary system that may comprise the asset 20. The primary system may further comprise components suitable for protection of the asset 20, such as a circuit breaker or switchgear 281. The electric power system may further comprise an automation control system 290. The automation control system 290 may comprise a plurality of intelligent electronic devices (IEDs). The automation control system 290 may comprise a communication system 300 that allows the intelligent electronic devices to communicate with each other and/or with a control system 49. An HMI 299 may be coupled to or comprised by the control system 49. The communication system 300 may comprise communication infrastructure, such as a communication switched 301, to enable communication between the IEDs. As previously explained, the system 10 comprises measurement instrumentation 41 operative to capture measurement data of the asset 20, such as thermal images or other thermal measurements. The system 10 further comprises a processing system 50 operative to process the measurements to determine one or several parameters in a manner that is at least spatially resolved, in the sense that the one or several parameters are determined for a plurality of locations on a tank of the asset 20.

Figure 31 shows a system 10 comprising a first IED 291 operative to perform control and/or monitoring functions for the asset 20. The asset 20 may be a power transformer or shunt reactor, without being limited thereto. The system 10 comprises a second IED 292 operative to cause the switchgear 281 to trip. The system 10 may be operative such that the processing system 50 generates output that causes at least one of the IEDs 291, 292 to perform an operation responsive on the output of the processing system 50, with the output of the processing system 50 being dependent on the determined at least one parameter. Alternatively or additionally, the system 10 may be operative such that the processing system 50 generates output that causes a warning, alert, alarm, or other status information relating to the asset 20 to be provided via the HMI 299, with the warning, alert, alarm, or other status information being dependent on the determined at least one parameter.

Figure 32 shows a modification of the system of Figure 30. In Figure 31, at least one IED 291 of the system 10 comprises the processing system operative as disclosed herein.

The techniques disclosed herein are particularly applicable to electric power systems that comprise distributed energy resources or other renewable energy sources and/or a time coupling equipment such as vehicles charging equipment.

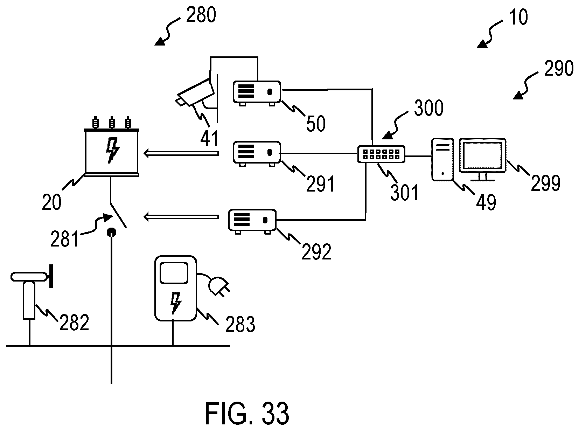

Figure 33 shows a system 10 comprising the processing system 50, wherein the electric power system comprises primary system equipment 280 that includes both the asset 20 and at least one of a renewable energy source 282 and electric vehicle charging equipment 283.

The techniques disclosed herein are also particularly applicable to electric power systems that comprise a high voltage direct current (HVDC) system.

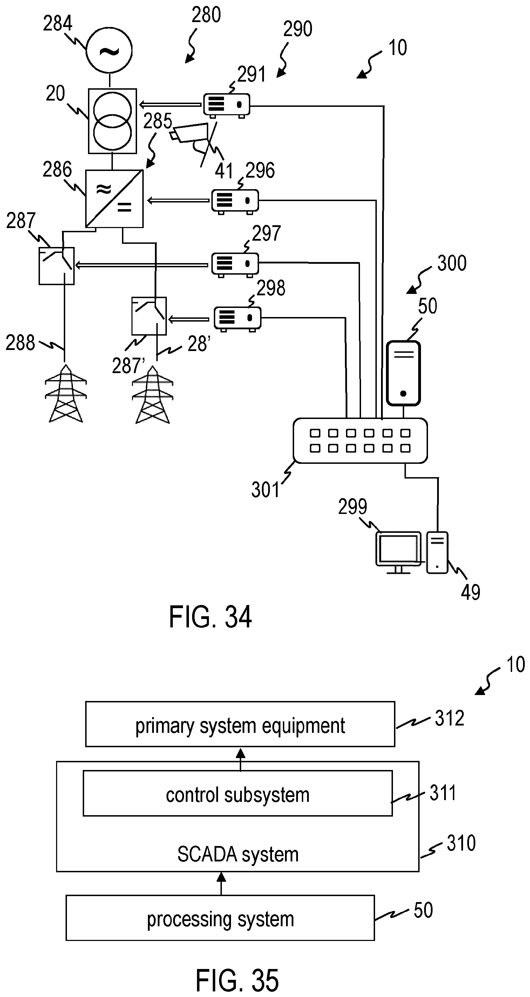

Figure 34 shows a system 10 comprising the processing system 50. The primary system equipment 280 comprises a power transformer 20 coupled to an AC system 284 and an inverter/converter 286. The primary system equipment 280 comprises the HVDC system 285. The HVDC system 285 comprises DC transmission lines or cables that may be implemented in a redundant manner by DC transmission lines or cables 288, 288'. The HVDC system 285 comprises protection equipment such as disconnectors 287, 287' for the lines or cables 288, 288'.

The system 10 comprises measurement instrumentation 41. The processing system 50 may be operative to generate output that causes at least one IED of the automation control system 290 to operate based on the output of the processing system 50. The output of the processing system 50 is dependent on the predicted parameter value. The system 10 may be operative such that at least one of an IED 291 associated with a power transformer 20, an IED 296 associated with the converter/inverter 286, an IED 297, 298 associated with a disconnector 287, 287' is caused to operate based on the output of the processing system 50 in a manner which affects the primary system equipment 280.

Figure 35 shows a schematic representation of a system 10 that comprises the processing system 50. The system 10 further comprises a SCADA system 310 comprising a control subsystem 311. The control subsystem 311 is operative to control primary system equipment 312 based on output generated by the processing system 50. The control subsystem 311 may be operative to change operation of the asset 20, for which the processing system 50 determines at least one parameter, or of other primary system equipment that is related to operation of the asset 20. For illustration, identification of a local loss in the asset 20 by the processing system 50 may cause the control subsystem 311 to change a load current and/or load power of the asset, to change a tap changer position, or to perform yet another control action suitable to mitigate the potentially critical situations.

Various effects and advantages are attained by the processing system, method, and system according to embodiments. The processing system and method provide enhanced techniques of determining at least one parameter in a spatially resolved manner for an asset, using a data-driven processing technique that has embedded therein physics knowledge. The techniques are operative to engineer input data for the physics informed data-driven processing technique in such a manner that measurements that do not reflect the physical relationship embedded in the physics informed data-driven processing technique are discarded or replaced.

The processing system and method allow temperature and/or heat to be determined using a PIML model, enabling the temperature and/or heat to be determined also for regions on a tank sidewall and/or tank cover at which measurements are unreliable or not available.

While embodiments have been described in detail with reference to the drawings, various modifications may be implemented in other embodiments. For illustration rather than limitation:

- While embodiments have been described in association with an asset that comprises a power transformer or shunt reactor having a tank, the techniques may also be used in association with other equipment, such as measurement transformers.
- While embodiments have been described in which the processing system 50 is comprised by or communicatively interfaced with a SCADA system, the processing system 50 can also be used in other use cases, e.g., to perform offline asset analysis.
- While embodiments have been described in which the PIML model has embedded therein a thermal diffusion equation and is trained to predict temperature and/or heat and an uncertainty measure for temperature and/or heat in a spatially resolved manner, the techniques disclosed herein are not limited to this use case. For illustration, the techniques disclosed herein may be used in association with PDEs other than thermal diffusion, in particular in association with other physical parameters of an asset that have to fulfill a PDE that links a first order partial time derivative and a second order spatial derivative (such as a 2D or 3D Laplace operator) to each other and/or to another parameter.
- The techniques disclosed herein may be used to predict both a mean and an uncertainty measure (such as a variance or logarithm of a variance) of a probability distribution for at least one parameter in a spatially resolved manner. Thus, the techniques disclosed herein may use the processing techniques disclosed in applicant's application EP23209949.9 entitled "METHOD AND PROCESSING SYSTEM FOR USE WITH AN ASSET OF AN ELECTRIC POWER SYSTEM" (patent application publication EP 4 556 928 A1) filed on the same day as the present application.

Embodiments may be used in association with a power grid having renewables penetration, such as power grid comprising renewable energy systems (such as DERs), and/or in association with a power grid having a HVDC system, without being limited thereto.

This description and the accompanying drawings that illustrate aspects and embodiments of the present invention should not be taken as limiting-the claims defining the protected invention. In other words, while the invention has been illustrated and described in detail in the drawings and foregoing description, such illustration and description are to be considered illustrative and not restrictive. Various mechanical, compositional, structural, electrical, and operational changes may be made without departing from the scope of the claims. In some instances, well-known circuits, structures and techniques have not been shown in detail in order not to obscure the invention. Thus, it will be understood that changes and modifications may be made by those of ordinary skill within the scope of the following claims. In particular, the present invention covers further embodiments with any combination of features from different embodiments described above and below.

The disclosure also covers all further features shown in the Figures individually although they may not have been described in the afore or following description. Also, single alternatives of the embodiments described in the Figures and the description and single alternatives of features thereof can be disclaimed from the subject matter of the invention or from disclosed subject matter. The disclosure comprises subject matter consisting of the features defined in the claims or the embodiments as well as subject matter comprising said features.

The term "comprising" does not exclude other elements or process blocks, and the indefinite article "a" or "an" does not exclude a plurality. A single unit or process block may fulfil the functions of several features recited in the claims. The mere fact that certain measures are recited in mutually different dependent claims does not indicate that a combination of these measures cannot be used to advantage. Components described as coupled or connected may be electrically or mechanically directly coupled, or they may be indirectly coupled via one or more intermediate components. Any reference signs in the claims should not be construed as limiting the scope.

A machine-readable instruction code may be stored/distributed on a suitable medium, such as an optical storage medium or a solid-state medium supplied together with or as part of other hardware, but may also be distributed in other forms, such as via a wide area network or other wired or wireless telecommunication systems. Furthermore, a machine-readable instruction code can also be a data structure product or a signal for embodying a specific method such as the method according to embodiments.

## Claims

1. A method for use in association with an asset (20) of an electric power system (10), the method comprising:

   receiving, at at least one interface (51) of a processing system (50), data comprising measurements (91) for several different measurement locations at or in proximity to the asset (20),
   performing, by at least one processing circuit (60) of the processing system (50), a determination of at least one parameter of the asset (20), comprising

   generating input data (65) for a physics informed data-driven processing technique (63; 120; 130) based at least on the measurements (91), comprising identifying a subset of the measurement locations for which the measurements (91) are reliable and using measurements (91) obtained at the identified subset for generating the input data (65), and
   applying the physics informed data-driven processing technique (63; 120; 130) to the input data (65) to determine the at least one parameter, and

   generating, by the processing system (50), output (59) based on the at least one parameter.

2. The method of claim 1, wherein the measurements (91) comprise spatially resolved temperature measurements (91), wherein identifying the subset of measurement locations comprises at least one of performing an image segmentation based on a temperature gradient determined from the temperature measurements (91) and/or based on construction data for the asset (20), wherein the at least one parameter is indicative of electric loss power.

3. The method of claim 2, wherein the spatially resolved temperature measurements (91) comprise pixel or voxel values of at least one thermal image of at least one wall (31, 32, 35) of a tank (30) of the asset (20).

4. The method of any one of the preceding claims, wherein the physics informed data-driven processing technique (63; 120; 130) comprises at least one physics informed machine learning, PIML, model (120; 130).

5. The method of claim 4, wherein the at least one PIML model (120; 130) has at least one output operative to provide a temperature and a heat determined by the at least one PIML model (120; 130).

6. The method of claim 5, wherein the at least one PIML model (130) comprises a first plurality of neural network, NN, layers (131) having a first output (133) and a first input (131) operative to receive the input data (65), a second plurality of NN layers (134) having a second output (136) operative to provide the temperature and having a second input (135) operative to receive first output data provided by the first output (133), and a third plurality of NN layers having a third plurality of NN layers (137) having a third output (139) operative to provide the heat and having a third input (138) operative to receive first output data provided by the first output (133).

7. The method of any one of claims 4 to 6, wherein the at least one PIML model (120; 130) embeds a thermal diffusion partial differential equation, PDE.

8. The method of any one of claims 4 to 7, wherein the at least one PIML model (120; 130) comprises at least one output layer operative to enforce positivity of the temperature and the heat determined by the at least one PIML model (120; 130).

9. The method of any one of the preceding claims, wherein the method further comprises training, by the processing system (50) or by a computing system (170) separate from the processing system (50), the at least one physics informed data-driven processing technique (63; 120; 130), wherein the training comprises a history-aware training,

optionally wherein the history-aware training is performed using a loss function to be maximized or minimized, wherein the loss function at least one of:

includes a weight factor that is dependent on a training loss in a past time instant of the training;
introduces a temporal gradient regularization;
penalizes a training loss based on a derivative of the loss function;

optionally wherein the method further comprises interfacing, by the processing system (50) or by the computing system (170), with an asset simulator (169) that simulates thermal behavior of the asset (20) to perform a model validation of the at least one physics informed data-driven processing technique (63; 120; 130).

10. The method of any one of the preceding claims, wherein the asset (20) comprises a transformer and/or a shunt reactor.

11. A method of controlling an electric power system (10), comprising:

performing, by a processing system (50), the method of any one of the preceding claims to determine an electric loss power in the asset (20) of the electric power system (10), and
performing, by the processing system (50) or a control system (49) operatively coupled with the processing system (50), at least one control operation based on the output (59).

12. A method of providing a physics informed machine learning, PIML, model (120; 130), the method comprising:

obtaining, by a computing system (170), training data (178) that are based on measurements (91) captured on a tank wall (31, 32, 35) of the asset (20),
training, by the computing system (170), the PIML model (80) using the training data (178), wherein the training comprises a history aware training in which a loss function at a training time instant is dependent on a loss function in at least one past training time instant of the training, and
providing PIML model data obtained in the training for use in the method of any one of the preceding claims.

13. The method of claim 12, wherein the history aware training is dependent on a time derivative of the loss function, and the method further comprises a PIML model validation, wherein the PIML model validation comprises using a spatially resolved heat prediction provided by the PIML model to determine, by the computing system (170) or a simulator (169) communicatively interfaced with the computing system (170), a spatially resolved simulated temperature distribution, and comparing the spatially resolved simulated temperature distribution with spatially resolved temperature measurements.

14. Machine-readable instruction code which, when executed by at least one programmable circuit, causes the at least one programmable circuit to perform the method of any one of the preceding claims.

15. A processing system (50) for use in association with an asset (20) of an electric power system (10), the processing system (50) comprising:

at least one interface (51) operative to receive data (58) comprising measurements (91) for several different measurement locations at or in proximity to the asset (20),
at least one processing circuit (60) operative to perform a determination of at least one parameter of the asset (20), wherein the at least one processing circuit (60) is operative to

generate input data (65) for a physics informed data-driven processing technique (63; 120; 130) based at least on the measurements (91), comprising identifying a subset of the measurement locations for which the measurements (91) are reliable and using measurements (91) obtained at the identified subset to generate the input data (65), and
apply the physics informed data-driven processing technique (63; 120; 130) to the input data (65) to determine the at least one parameter,

wherein the processing system (50) is operative to generate output (59) based on the at least one parameter.

**Patentansprüche**

1.  Verfahren zur Anwendung im Zusammenhang mit einem Betriebsmittel (20) eines elektrischen Energieversorgungssystems (10), wobei das Verfahren aufweist:

    Empfangen, an mindestens einer Schnittstelle (51) eines Verarbeitungssystems (50), von Daten, die Messungen (91) für mehrere unterschiedliche Messorte an dem Betriebsmittel (20) oder in Nähe des Betriebsmittels (20) aufweisen,
    Durchführen, durch mindestens eine Verarbeitungsschaltung (60) des Verarbeitungssystems (50), einer Bestimmung mindestens eines Parameters des Betriebsmittels (20), aufweisend

    Erzeugen von Eingangsdaten (65) für eine physikalisch informierte datengetriebene Verarbeitungstechnik (63; 120; 130) basierend zumindest auf den Messungen (91), aufweisend ein Identifizieren einer Teilmenge der Messorte, für die die Messungen (91) zuverlässig sind, und ein Verwenden von Messungen (91), die an der identifizierten Teilmenge gewonnen wurden, zum Erzeugen der Eingangsdaten (65), und
    Anwenden der physikalisch informierten datengetriebenen Verarbeitungstechnik (63; 120; 130) auf die Eingangsdaten (65), um den mindestens einen Parameter zu bestimmen, und

    Erzeugen einer Ausgabe (59) durch das Verarbeitungssystem (50) basierend auf dem mindestens einen Parameter.

2.  Verfahren nach Anspruch 1, wobei die Messungen (91) ortsaufgelöste Temperaturmessungen (91) aufweisen, wobei das Identifizieren der Teilmenge der Messorte mindestens eines aus Folgendem aufweist: Durchführen einer Bildsegmentierung basierend auf einem aus den Temperaturmessungen (91) bestimmten Temperaturgradienten und/oder basierend auf Konstruktionsdaten für das Betriebsmittel (20), wobei der mindestens eine Parameter eine elektrische Verlustleistung angibt.

3.  Verfahren nach Anspruch 2, wobei die ortsaufgelösten Temperaturmessungen (91) Pixel-oder Voxelwerte mindestens eines Wärmebildes mindestens einer Wand (31, 32, 35) eines Tanks (30) des Betriebsmittels (20) aufweisen.

4.  Verfahren nach einem der vorhergehenden Ansprüche, wobei die physikalisch informierte datengetriebene Verarbeitungstechnik (63; 120; 130) mindestens ein physikalisch informiertes Maschinenlern, PIML, -Modell (120; 130), aufweist.

5.  Verfahren nach Anspruch 4, wobei das mindestens eine PIML-Modell (120; 130) mindestens einen Ausgang aufweist, der eingerichtet ist, eine Temperatur und eine durch das mindestens eine PIML-Modell bestimmte Wärme bereitzustellen.

6.  Verfahren nach Anspruch 5, wobei das mindestens eine PIML-Modell (130) aufweist: eine erste Mehrzahl von neuronalen Netzwerk, NN,-Schichten (131) mit einem ersten Ausgang (133) und einem ersten Eingang (131), der eingerichtet ist zum Empfangen der Eingangsdaten (65), eine zweite Mehrzahl von NN-Schichten (134) mit einem zweiten Ausgang (136), der eingerichtet ist zum Bereitstellen der Temperatur, und einem zweiten Eingang (135), der eingerichtet ist zum Empfangen von durch den ersten Ausgang (133) bereitgestellten ersten Ausgangsdaten, und eine dritte Mehrzahl von NN-Schichten (137) mit einem dritten Ausgang (139), der eingerichtet ist zum Bereitstellung der Wärme, und einem dritten Eingang (138), der eingerichtet ist zum Empfangen der durch den ersten Ausgang (133) bereitgestellten ersten Ausgangsdaten.

7.  Verfahren nach einem der Ansprüche 4 bis 6, wobei das mindestens eine PIML-Modell (120; 130) eine partielle Differenzialgleichung für thermische Diffusion einbettet.

8.  Verfahren nach einem der Ansprüche 4 bis 7, wobei das mindestens eine PIML-Modell (120; 130) mindestens eine Ausgangsschicht aufweist, die eingerichtet ist, eine Positivität der durch das mindestens eine PIML-Modell bestimmten Temperatur und Wärme zu erzwingen.

9.  Verfahren nach einem der vorhergehenden Ansprüche, wobei das Verfahren ferner aufweist:

Trainieren der mindestens einen physikalisch informierten datengetriebenen Verarbeitungstechnik (63; 120; 130) durch das Verarbeitungssystem (50) oder durch ein von dem Verarbeitungssystem (50) getrenntes Rechnersystem (170), wobei das Trainieren ein verlaufsbasiertes Training aufweist;
wobei optional das verlaufsbasierte Training unter Verwendung einer zu maximierenden oder zu minimierenden Verlustfunktion durchgeführt wird, wobei für die Verlustfunktion mindestens eines aus Folgendem zutrifft:

die Verlustfunktion weist einen Gewichtungsfaktor auf, der von einem Trainingsverlust in einem vergangenen Zeitpunkt des Trainings abhängt;
die Verlustfunktion führt eine zeitliche Gradientenregularisierung ein;
die Verlustfunktion bestraft einen Trainingsverlust basierend auf einer Ableitung der Verlustfunktion;

wobei optional das Verfahren ferner aufweist: Interagieren, durch das Verarbeitungssystem (50) oder durch das Rechnersystem (170), mit einem Betriebsmittel-Simulator (169), der ein thermisches Verhalten des Betriebsmittels (20) simuliert, um eine Modellvalidierung der mindestens einen physikalisch informierten datengetriebenen Verarbeitungstechnik (63; 120; 130) durchzuführen.

10. Verfahren nach einem der vorhergehenden Ansprüche, wobei das Betriebsmittel (20) einen Transformator und/oder einen Drosselreaktor aufweist.

11. Verfahren zum Steuern eines elektrischen Energieversorgungssystems (10), aufweisend:

Durchführen des Verfahrens nach einem der vorhergehenden Ansprüche durch ein Verarbeitungssystem (50), um eine elektrische Verlustleistung im Betriebsmittel (20) des elektrischen Energieversorgungssystems (10) zu bestimmen, und
Durchführen mindestens einer Steuerungsoperation durch das Verarbeitungssystem (50) oder durch ein mit dem Verarbeitungssystem (50) gekoppeltes Steuersystem (49) basierend auf der Ausgabe (59).

12. Verfahren zum Bereitstellen eines physikalisch informierten Maschinenlern, PIML, -Modells (120; 130), aufweisend:

Erhalten von Trainingsdaten (178) durch ein Rechnersystem (170), wobei die Trainingsdaten (178) auf Messungen (91) basieren, die an einer Tankwand (31, 32, 35) des Betriebsmittels (20) erfasst wurden,
Trainieren des PIML-Modells (80) durch das Rechnersystem (170) unter Verwendung der Trainingsdaten (178), wobei das Trainieren ein verlaufsbasiertes Training aufweist, bei dem eine Verlustfunktion zu einem Trainingszeitpunkt von einer Verlustfunktion in mindestens einem vergangenen Trainingszeitpunkt abhängt, und
Bereitstellen von PIML-Modelldaten zur Verwendung beim Verfahren nach einem der vorhergehenden Ansprüche.

13. Verfahren nach Anspruch 12, wobei das verlaufsbasierte Training von einer Zeitableitung der Verlustfunktion abhängt, und wobei das Verfahren ferner eine PIML-Modellvalidierung aufweist, wobei die PIML-Modellvalidierung aufweist: Verwenden einer ortsaufgelösten Wärmevorhersage, die durch das PIML-Modell bereitgestellt wird, um durch das Rechnersystem (170) oder durch einen Simulator (169), der mit dem Rechnersystem (170) im Kommunikationsverbindung steht, eine ortsaufgelöste simulierte Temperaturverteilung zu bestimmen, und Vergleichen der ortsaufgelösten simulierten Temperaturverteilung mit ortsaufgelösten Temperaturmessungen.

14. Maschinenlesbarer Instruktionscode, der bei Ausführung durch mindestens eine programmierbare Schaltung die mindestens eine programmierbare Schaltung zur Durchführung des Verfahrens nach einem der vorhergehenden Ansprüche veranlasst.

15. Verarbeitungssystem (50) zur Anwendung im Zusammenhang mit einem Betriebsmittel (20) eines elektrischen Energieversorgungssystems (10), wobei das Verarbeitungssystem (50) aufweist:

mindestens eine Schnittstelle (51), die eingerichtet ist, Daten (58) zu empfangen, die Messungen (91) für mehrere unterschiedliche Messorte an dem Betriebsmittel (20) oder in der Nähe des Betriebsmittels (20) aufweisen,
mindestens eine Verarbeitungsschaltung (60), die eingerichtet ist, eine Bestimmung mindestens eines Parameters des Betriebsmittels (20) durchzuführen, wobei die mindestens eine Verarbeitungsschaltung (60) eingerichtet ist

Eingangsdaten (65) für eine physikalisch informierte datengetriebene Verarbeitungstechnik (63; 120; 130) basierend zumindest auf den Messungen (91) zu erzeugen, aufweisend ein Identifizieren einer Teilmenge der Messorte, für die die Messungen (91) zuverlässig sind, und das Verwenden von Messungen (91), die an der identifizierten Teilmenge gewonnen wurden, zur Erzeugung der Eingangsdaten (65), und die physikalisch informierte datengetriebene Verarbeitungstechnik (63; 120; 130) auf die Eingangsdaten (65) anzuwenden, um den mindestens einen Parameter zu bestimmen,

wobei das Verarbeitungssystem (50) eingerichtet ist, eine Ausgabe (59) basierend auf dem mindestens einen Parameter zu erzeugen.

## Revendications

1. Procédé destiné à être utilisé en association avec un équipement (20) d'un système d'alimentation électrique (10), le procédé comprenant :

   la réception, au niveau d'au moins une interface (51) d'un système de traitement (50), de données comprenant des mesures (91) pour plusieurs emplacements de mesure différents au niveau ou à proximité de l'équipement (20),
   la réalisation, par au moins un circuit de traitement (60) du système de traitement (50), d'une détermination d'au moins un paramètre de l'équipement (20), comprenant
   la génération de données d'entrée (65) pour une technique de traitement piloté par des données informée par la physique (63 ; 120 ; 130) sur la base au moins des mesures (91), comprenant l'identification d'un sous-ensemble des emplacements de mesure pour lesquels les mesures (91) sont fiables et l'utilisation de mesures (91) obtenues au niveau du sous-ensemble identifié pour générer les données d'entrée (65), et
   l'application de la technique de traitement piloté par des données informée par la physique (63 ; 120 ; 130) aux données d'entrée (65) pour déterminer l'au moins un paramètre, et
   la génération, par le système de traitement (50), d'une sortie (59) sur la base de l'au moins un paramètre.

2. Procédé selon la revendication 1, dans lequel les mesures (91) comprennent des mesures de température résolues spatialement (91), dans lequel l'identification du sous-ensemble d'emplacements de mesure comprend au moins l'une parmi la réalisation d'une segmentation d'image sur la base d'un gradient de température déterminé à partir des mesures de température (91) et/ou sur la base de données de construction pour l'équipement (20), dans lequel l'au moins un paramètre indique une perte de puissance électrique.

3. Procédé selon la revendication 2, dans lequel les mesures de température résolues spatialement (91) comprennent des valeurs de pixel ou de voxel d'au moins une image thermique d'au moins une paroi (31, 32, 35) d'un réservoir (30) de l'équipement (20).

4. Procédé selon l'une quelconque des revendications précédentes, dans lequel la technique de traitement piloté par des données informée par la physique (63 ; 120 ; 130) comprend au moins un modèle d'apprentissage automatique informé par la physique (120 ; 130), PIML.

5. Procédé selon la revendication 4, dans lequel l'au moins un modèle PIML (120 ; 130) présente au moins une sortie adaptée pour fournir une température et une chaleur déterminées par l'au moins un modèle PIML (120 ; 130).

6. Procédé selon la revendication 5, dans lequel l'au moins un modèle PIML (130) comprend une première pluralité de couches de réseau de neurones (131), NN, présentant une première sortie (133) et une première entrée (131) adaptées pour recevoir les données d'entrée (65), une deuxième pluralité de couches NN (134) présentant une deuxième sortie (136) adaptée pour fournir la température et présentant une deuxième entrée (135) adaptée pour recevoir des premières données de sortie fournies par la première sortie (133), et une troisième pluralité de couches NN (137) présentant une troisième sortie (139) adaptée pour fournir la chaleur et présentant une troisième entrée (138) adaptée pour recevoir des premières données de sortie fournies par la première sortie (133).

7. Procédé selon l'une quelconque des revendications 4 à 6, dans lequel l'au moins un modèle PIML (120 ; 130) incorpore une équation différentielle partielle de diffusion thermique, PDE.

8. Procédé selon l'une quelconque des revendications 4 à 7, dans lequel le modèle PIML (120 ; 130) comprend au moins une couche de sortie adaptée pour imposer la positivité de la température et de la chaleur déterminées par l'au moins un modèle PIML (120 ; 130).

9. Procédé selon l'une quelconque des revendications précédentes, dans lequel le procédé comprend en outre l'entraînement, par le système de traitement (50) ou par un système informatique (170) distinct du système de traitement (50), de l'au moins une technique de traitement piloté par des données informée par la physique (63 ; 120 ; 130), dans lequel l'entraînement comprend un entraînement sensible à l'historique,
optionnellement, dans lequel l'entraînement sensible à l'historique est effectué à l'aide d'une fonction de perte à maximiser ou minimiser, dans lequel la fonction de perte au moins :

comporte un facteur de pondération qui dépend d'une perte d'entraînement à un instant passé de l'entraînement ; et/ou
introduit une régularisation de gradient temporel ; et/ou
pénalise une perte d'entraînement sur la base d'une dérivée de la fonction de perte ;
optionnellement, dans lequel le procédé comprend en outre l'interfaçage, par le système de traitement (50) ou par le système informatique (170), avec un simulateur d'équipement (169) qui simule le comportement thermique de l'équipement (20) pour effectuer une validation de modèle de l'au moins une technique de traitement piloté par des données informée par la physique (63 ; 120 ; 130).

10. Procédé selon l'une quelconque des revendications précédentes, dans lequel l'équipement (20) comprend un transformateur et/ou un réacteur shunt.

11. Procédé de commande d'un système d'alimentation électrique (10), comprenant :

la réalisation, par un système de traitement (50), du procédé selon l'une quelconque des revendications précédentes pour déterminer une perte de puissance électrique dans l'équipement (20) du système d'alimentation électrique (10), et
la réalisation, par le système de traitement (50) ou un système de commande (49) couplé fonctionnellement au système de traitement (50), d'au moins une opération de commande sur la base de la sortie (59).

12. Procédé de fourniture d'un modèle d'apprentissage automatique informé par la physique (120 ; 130), PIML, le procédé comprenant :

l'obtention, par un système informatique (170), de données d'entraînement (178) qui sont basées sur des mesures (91) capturées sur une paroi de réservoir (31, 32, 35) de l'équipement (20),
l'entraînement, par le système informatique (170), du modèle PIML (80) à l'aide des données d'entraînement (178), dans lequel l'entraînement comprend un entraînement sensible à l'historique dans lequel une fonction de perte à un instant d'entraînement dépend d'une fonction de perte dans au moins un instant d'entraînement passé de l'entraînement, et
la fourniture de données de modèle PIML obtenues lors de l'apprentissage pour utilisation dans le procédé selon l'une quelconque des revendications précédentes.

13. Procédé selon la revendication 12, dans lequel l'entraînement sensible à l'historique dépend d'une dérivée temporelle de la fonction de perte, et le procédé comprend en outre une validation de modèle PIML, dans lequel la validation de modèle PIML comprend l'utilisation d'une prédiction de chaleur résolue spatialement fournie par le modèle PIML pour déterminer, par le système informatique (170) ou un simulateur (169) interfacé en communication avec le système informatique (170), une distribution de température simulée résolue spatialement, et la comparaison de la distribution de température simulée résolue spatialement avec des mesures de température résolues spatialement.

14. Code d'instruction lisible par machine qui, lorsqu'il est exécuté par au moins un circuit programmable, amène l'au moins un circuit programmable à effectuer le procédé selon l'une quelconque des revendications précédentes.

15. Système de traitement (50) destiné à être utilisé en association avec un équipement (20) d'un système d'alimentation électrique (10), le système de traitement (50) comprenant :

au moins une interface (51) adaptée pour recevoir des données (58) comprenant des mesures (91) pour plusieurs emplacements de mesure différents au niveau ou à proximité de l'équipement (20),

au moins un circuit de traitement (60) adapté pour effectuer une détermination d'au moins un paramètre de l'équipement (20), dans lequel l'au moins un circuit de traitement (60) est adapté pour

générer des données d'entrée (65) pour une technique de traitement piloté par des données informée par la physique (63 ; 120 ; 130) sur la base au moins des mesures (91), comprenant l'identification d'un sous-ensemble des emplacements de mesure pour lesquels les mesures (91) sont fiables et l'utilisation de mesures (91) obtenues au niveau du sous-ensemble identifié pour générer les données d'entrée (65), et

appliquer la technique de traitement piloté par des données informée par la physique (63 ; 120 ; 130) aux données d'entrée (65) pour déterminer l'au moins un paramètre,

dans lequel le système de traitement (50) est adapté pour générer une sortie (59) sur la base de l'au moins un paramètre.

FIG. 1

FIG. 2

FIG. 3

preprocessing measurements — 81

determining parameter(s) using data-driven processing technique — 82

causing action to be performed based on the determined parameter(s) — 83

80

FIG. 4

FIG. 5

FIG. 6

FIG. 7

FIG. 8

FIG. 9

FIG. 10

FIG. 11

FIG. 12

FIG. 13

FIG. 14

EP 4 556 929 B1

FIG. 15

FIG. 16

FIG. 17

FIG. 18

FIG. 19

181

training NN part for first parameter

180

↓

182

training NN part for second parameter

↓

183

training NN parts for first and second parameters in tandem

## FIG. 20

165

161

obtaining training data

↓

162

preprocessing training data

↓

166

performing history aware training of ML model

## FIG. 21

FIG. 22

FIG. 23

```
┌─────────────────────────────────────┐
│          PIML model training         │ ⟋ 201        ⟋ 200
└─────────────────────────────────────┘
                    │
                    ▼
┌─────────────────────────────────────┐
│          PIML model validation       │ ⟋ 202
└─────────────────────────────────────┘
```

## FIG. 24

```
┌─────────────────────────────────────┐
│  using PIML to predict heat distribution │ ⟋ 211        ⟋ 210
└─────────────────────────────────────┘
                    │
                    ▼
┌─────────────────────────────────────┐
│  reconstructing temperature distribution │ ⟋ 212
└─────────────────────────────────────┘
                    │
                    ▼
┌─────────────────────────────────────┐
│  comparing temperature measurements  │ ⟋ 213
│   and reconstructed temperature      │
│            distribution              │
└─────────────────────────────────────┘
```

## FIG. 25

FIG. 26

EP 4 556 929 B1

FIG. 27

FIG. 28

FIG. 29

FIG. 30

FIG. 31

FIG. 32

FIG. 33

FIG. 34

FIG. 35

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200293594 A1

**Non-patent literature cited in the description**

- Physics-informed neural networks for modelling power transformer's dynamic thermal behaviour. **F. BRAGONE et al.** Electric Power Systems Research. Elsevier, October 2022, vol. 211, 108447

- **C. MOYA et al.** DeepONet-Grid-UQ: A Trustworthy Deep Operator Framework for Predicting the Power Grid's Post-Fault Trajectories. *arXiv:2202.07176*